# EUROPEAN PATENT APPLICATION

(11) **EP 4 848 970 A1**
(43) Date of publication of application: **02.12.2026**
(21) Application number: 26171335.8
(22) Date of filing: 09.04.2026
(51) Int. Cl.: H10W 42/00, H10P 54/00, H10P 74/00

(54) **INTEGRATED CIRCUIT DEVICE INCLUDING CHIPPING DAM SURROUNDING GUARD RING**

(30) Priority: 30.05.2025 KR 20250071364
(71) Applicant: Samsung Electronics Co., Ltd., Suwon-si, Gyeonggi-do 16677 (KR)
(72) Inventor: PARK, Dongsik, 16677 Suwon-si, Gyeonggi-do (KR); KIM, Changsik, 16677 Suwon-si, Gyeonggi-do (KR); SONG, Jaejoon, 16677 Suwon-si, Gyeonggi-do (KR); JUNG, Uihyeon, 16677 Suwon-si, Gyeonggi-do (KR); LEE, Kyusun, 16677 Suwon-si, Gyeonggi-do (KR); HAN, Minchul, 16677 Suwon-si, Gyeonggi-do (KR)
(74) Representative: Kuhnen & Wacker Patent- und Rechtsanwaltsbüro PartG mbB

(57) **Abstract**

An integrated circuit device (100) may include a guard ring (GRA) and a chipping dam (CPDA) at a first vertical level on a substrate. The first vertical level may be apart from a main surface of the substrate in a vertical direction orthogonal to the main surface. The chipping dam (CPDA) may surround the guard ring (GRA). The guard ring (GRA) and the chipping dam (CPDA) each may include a lower guard ring and an upper guard ring structure spaced apart in the vertical direction from the substrate with the lower guard ring therebetween. The lower guard ring may include a first mesh structure defining a plurality of first polygonal vertical holes in a top view. The upper guard ring structure may include at least one upper guard ring. The at least one upper guard ring may include a second mesh structure defining a plurality of second polygonal vertical holes in the top view.

## Description

### BACKGROUND

Inventive concepts relate to an integrated circuit (IC) device, and more particularly, to an IC device including a crack propagation blocking structure arranged around a main chip area.

Due to the development of electronic technology, downscaling of an IC device including a semiconductor chip has rapidly progressed. The semiconductor chip may be individualized by performing a physical cutting process on a wafer in a scribe lane area of the wafer. As the demand for high-capacity highly integrated IC devices increases, an area occupied by the scribe lane area on the wafer has been reduced. Accordingly, it may be beneficial to develop a technique capable of limiting and/or preventing damage caused by propagation of cracks, chipping, or breakage from occurring in a semiconductor chip due to stress applied to the semiconductor chip during a physical cutting process for individualizing the semiconductor chip.

### SUMMARY

Inventive concepts provide an integrated circuit (IC) device having improved reliability and productivity by limiting and/or blocking the propagation of cracks, chipping, or breakage that may occur when a physical cutting process for individualizing the IC device is performed during a process of manufacturing the IC device.

According to an aspect of inventive concepts, an integrated circuit device may include a substrate; a guard ring at a first vertical level on the substrate, wherein the first vertical level may be spaced apart from a main surface of the substrate in a vertical direction and the vertical direction may be orthogonal to the main surface; and a chipping dam at the first vertical level on the substrate, the chipping dam surrounding the guard ring. The guard ring and the chipping dam each may include a lower guard ring and an upper guard ring structure spaced apart in the vertical direction from the substrate with the lower guard ring therebetween. The lower guard ring may include a first mesh structure defining a plurality of first polygonal vertical holes in a top view. The upper guard ring structure may include at least one upper guard ring, and the at least one upper guard ring may include a second mesh structure defining a plurality of second polygonal vertical holes in the top view.

According to another aspect of inventive concepts, an IC device may include a substrate having a main chip area and an edge area surrounding the main chip area in a top view; a guard ring on the edge area of the substrate, the guard ring surrounding the main chip area in the top view; and a chipping dam on the edge area of the substrate and spaced apart in a lateral direction from the main chip area with the guard ring therebetween, the chipping dam surrounding the main chip area and the guard ring in the top view, wherein the lateral direction is parallel to a main surface of the substrate. The guard ring and the chipping dam each may include a lower guard ring and an upper guard ring structure spaced apart in a vertical direction from the substrate with the lower guard ring therebetween. The lower guard ring may include a first mesh structure defining a plurality of first polygonal vertical holes in the top view. The upper guard ring structure may include at least one upper guard ring, and the at least one upper guard ring may include a second mesh structure defining a plurality of second polygonal vertical holes in the top view.

According to another aspect of inventive concepts, an IC device may include a substrate having a main chip area and an edge area surrounding the main chip area in a top view; a guard ring on the edge area of the substrate and surrounding the main chip area in the top view; a chipping dam on the edge area of the substrate and surrounding the main chip area and the guard ring in the top view, the chipping dam being spaced apart in a lateral direction from the main chip area with the guard ring therebetween, wherein the lateral direction is parallel to a main surface of the substrate; and a moat structure between the guard ring and the chipping dam on the edge area of the substrate, the moat structure surrounding the main chip area and the guard ring, the moat structure comprising a metal moat pattern having a U cross-sectional shape defining an inner space. The guard ring and the chipping dam each may include a lower guard ring and an upper guard ring structure spaced apart in a vertical direction from the substrate with the lower guard ring therebetween. The lower guard ring may include a first mesh structure defining a plurality of first polygonal vertical holes in the top view. The upper guard ring structure may include at least one upper guard ring, and the at least one upper guard ring may include a second mesh structure defining a plurality of second polygonal vertical holes in the top view. A vertical level of an uppermost top surface of the metal moat pattern may be farther from the substrate than a vertical level of an uppermost top surface of the guard ring and a vertical level of an uppermost top surface of the chipping dam.

According to another aspect of inventive concepts, a method of manufacturing an IC device may include providing a plurality of main chip areas and a scribe lane area between two adjacent ones of the plurality of main chip areas. A lower guard ring is formed on the substrate in the scribe lane area. In the scribe lane area, an upper guard ring structure including at least one upper guard ring is formed on the lower guard ring. The lower guard ring includes a first mesh structure defining a plurality of first polygonal vertical holes in a top view, and the at least one upper guard ring includes a second mesh structure defining a plurality of second polygonal vertical holes in a top view.

In embodiments, during the formation the lower guard ring, each of the plurality of first polygonal vertical holes included in the lower guard ring may include a hexagonal hole, and the lower guard ring may be formed to have a network structure in which a plurality of unit structures each having a honeycomb shape are integrally connected to each other.

In other embodiments, during the formation of the upper guard ring structure, each of the plurality of second polygonal vertical holes included in the at least one upper guard ring may include a hexagonal hole, and the at least one upper guard ring may be formed to have a network structure in which a plurality of unit structures each having a honeycomb shape are integrally connected to each other.

In other embodiments, during the formation of the upper guard ring structure, the upper guard ring structure may be formed to include a plurality of upper guard rings and a plurality of guard via contacts. The plurality of upper guard rings may overlap each other in the vertical direction and be spaced apart from each other in the vertical direction. The plurality of guard via contacts may be located between a pair of upper guard rings, which are selected from the plurality of upper guard rings and are adjacent to each other in the vertical direction. The plurality of guard via contacts may be connected to each of the pair of upper guard rings.

The method of manufacturing the IC device may further include forming a wiring structure on each of the plurality of main chip areas. The formation of the lower guard ring may be performed simultaneously with forming a portion of the wiring structure, and the formation of the upper guard ring structure may be performed simultaneously with forming another portion of the wiring structure.

After the formation of the upper guard ring structure, the method of manufacturing the IC device may further include forming a hole passing through the at least one upper guard ring in a vertical direction and forming a metal moat pattern conformally covering an inner surface of the hole. The hole may have a bottom portion exposing the lower guard ring. The metal moat pattern may have a surface in contact with the lower guard ring and a surface in contact with the at least one upper guard ring, and a vertical level of a top surface of the metal moat pattern, which is farthest from the substrate, may be farther from the substrate than a vertical level of a top surface of the upper guard ring structure, which is farthest from the substrate.

The method of manufacturing the IC device may further include forming a wring structure on each of the plurality of main chip areas and forming a plurality of redistribution layers configured to be connected to the wiring structure on the plurality of main chip areas. The formation of the metal moat pattern may be performed simultaneously with forming the plurality of redistribution layers.

In the method of manufacturing the IC device, during the formation of the lower guard ring, each of a plurality of first bar components defining the plurality of first polygonal vertical holes, of the first mesh structure included in the lower guard ring, may be formed to have a first thickness in a lateral direction that is parallel to a main surface of the substrate. During the formation of the upper guard ring structure, each of a plurality of second bar components defining the plurality of second polygonal vertical holes, of the second mesh structure included in the at least one upper guard ring, may be formed to have a second thickness in the lateral direction. In embodiments, the first thickness may be equal to the second thickness. In other embodiments, the first thickness may be different from the second thickness.

### BRIEF DESCRIPTION OF THE DRAWINGS

Embodiments will be more clearly understood from the following detailed description taken in conjunction with the accompanying drawings in which:
FIG. 1 is a schematic plan view of an integrated circuit (IC) device according to embodiments;
FIG. 2 is a cross-sectional view of some components corresponding to a cross-section taken along line X1 - X1' of FIG. 1;
FIG. 3 is a schematic perspective view of a partial region "EX1" of FIG. 2;
FIG. 4A is a schematic perspective view of a partial region of a lower guard ring of an IC device according to embodiments;
FIG. 4B is a plan view of a partial region of a lower guard ring of an IC device according to embodiments;
FIG. 5A is a schematic perspective view of a partial region of an upper guard ring included in an upper guard ring structure of an IC device according to embodiments;
FIG. 5B is a plan view of a partial region of an upper guard ring of an IC device according to embodiments;
FIG. 6 is a schematic plan view of an outermost edge portion of an IC device according to embodiments;
FIG. 7A is a schematic perspective view of a partial region of a lower guard ring of an IC device according to other embodiments;
FIG. 7B is a plan view of a partial region of a lower guard ring of an IC device according to other embodiments;
FIG. 7C is a schematic perspective view of a partial region of an upper guard ring of an IC device according to other embodiments;
FIG. 7D is a plan view of a partial region of an upper guard ring of an IC device according to other embodiments;
FIG. 8 is a plan view of an IC device according to still other embodiments;
FIGS. 9A and 9B are each a plan view of a guard ring and a chipping dam of an IC device according to still other embodiments;
FIGS. 10 and 11 are cross-sectional views of semiconductor packages according to embodiments;
FIG. 12 is a plan view of a wafer that may be used in a method of manufacturing an IC device, according to embodiments; and
FIGS. 13A, 13B, 13C, and 13D are cross-sectional views of a process sequence of a method of manufacturing an IC device according to embodiments.

### DETAILED DESCRIPTION OF THE EMBODIMENTS

Hereinafter, embodiments will be described in detail with reference to the accompanying drawings. The same reference numerals are used to denote the same elements in the drawings, and repeated descriptions thereof will be omitted.

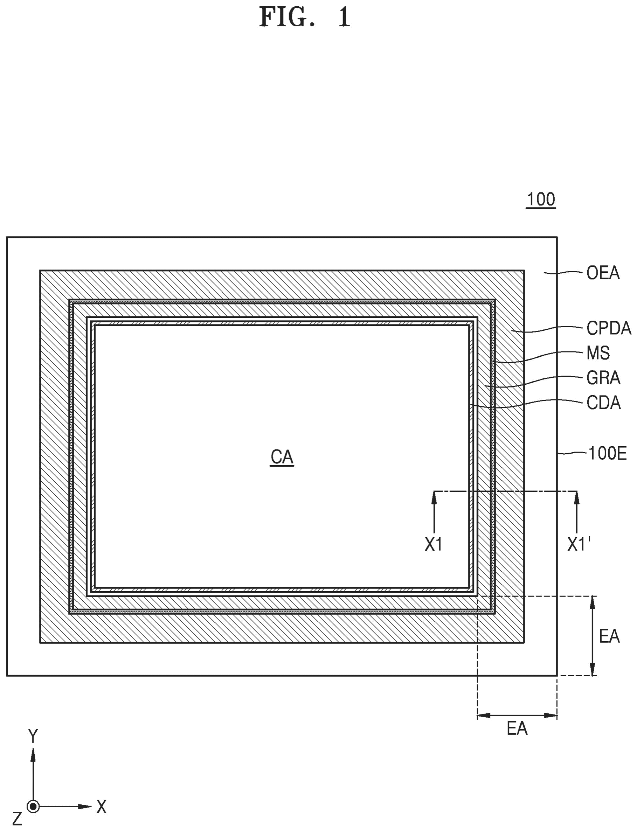

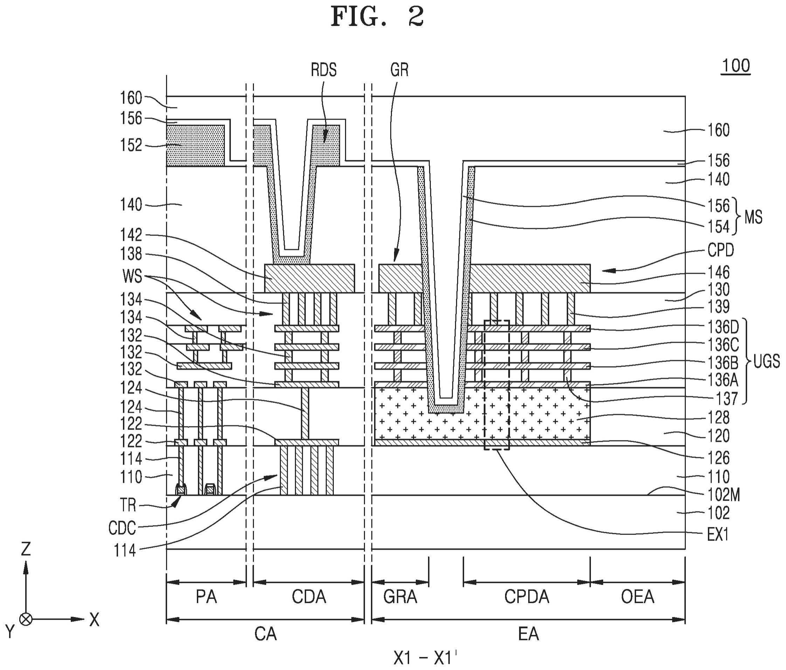

FIG. 1 is a schematic plan view of an integrated circuit (IC) device 100 according to embodiments. FIG. 2 is a cross-sectional view of some components corresponding to a cross-section taken along line X1 - X1' of FIG. 1.

Referring to FIGS. 1 and 2, the IC device 100 may include a substrate 102 having a main chip area CA and an edge area EA. The main chip area CA may be substantially in a center of the IC device 100, and the edge area EA may surround the main chip area CA outside the main chip area CA in a top view. As used herein, a top view refers to a view seen from an X-Y plane in the accompanying drawings. In a top view, the IC device 100 may substantially have a rectangular shape. However, according to inventive concepts, a planar shape of the IC device 100 is not limited to the rectangular shape and may be various planar shapes as needed.

In embodiments, the substrate 102 may include a semiconductor substrate or a semiconductoron-insulator substrate, such as a silicon substrate or a silicon-on-insulator (SOI) substrate. In some embodiments, the substrate 102 may include a semiconductor element, such as germanium (Ge), or a compound semiconductor, such as silicon carbide (SiC), gallium arsenide (GaAs), indium arsenide (InAs), and indium phosphide (InP). The substrate 102 may include a conductive region, for example, a doped well or a doped structure. The substrate 102 may include various device isolation structures, such as a shallow trench isolation (STI) structure. The substrate 102 may have a main surface 102M extending along the X-Y plane. A plurality of circuits may be arranged on a main surface 102M of the substrate 102.

Various elements may be arranged on the main chip area CA of the substrate 102. For example, devices selected from memory devices and logic devices may be located on the main chip area CA of the substrate 102. The memory devices may include dynamic random-access memory (DRAM), static RAM (SRAM), flash memory, electrically erasable and programmable read-only memory (EEPROM), phase-change RAM (PRAM), magnetic RAM (MRAM), or resistive RAM (RRAM), without being limited thereto. The logic devices may include an AND, a NAND, an OR, a NOR, an exclusive OR (XOR), an exclusive NOR (XNOR), an inverter (INV), an adder (ADD), a buffer (BUF), a delay (DLY), a filter (FIL), a multiplexer (MXT/MXIT), an OR/AND/INVERTER (OAI), an AND/OR (AO), an AND/OR/INVERTER (AOI), a D-flip-flop, a reset flip-flop, a master-slave flip-flop, a latch, a counter, or a buffer, without being limited thereto. Also, the logic devices may include a central processing unit (CPU), a micro-processor unit (MPU), a graphic processing unit (GPU), or an application processor (AP).

In embodiments, the IC device 100 may include a DRAM chip including DRAM devices. For example, the IC device 100 may include a high-bandwidth memory (HBM) DRAM chip and constitute a portion of an HBM package. The HBM package may include a base chip and a plurality of DRAM chips stacked on the base chip. The base chip may be used as a buffer chip or a control chip. The base chip may combine signals transmitted from the plurality of DRAM chips and transmit the combined signals to the outside or may transmit signals and power transmitted from the outside to the plurality of DRAM chips. The IC device 100 may be used to form the HBM package through a Die to Wafer (D2W) process. The D2W may include stacking individual DRAM chips on a wafer, sealing the obtained resultant structure with a sealant, and individualizing the resultant structure into individual devices by using a sawing process.

Various types of individual devices may be located on the substrate 102 in the main chip area CA. The individual devices may include a complementary metal-oxide-semiconductor (CMOS) transistor, system large-scale integration (LSI), an image sensor such as a CMOS image sensor (CIS), microelectromechanical systems (MEMS), various active devices, and/or various passive devices.

In the main chip area CA, a plurality of interlayer insulating films (e.g., 110, 120, 130, and 140) may be stacked on the substrate 102 in a vertical direction (Z direction), which is perpendicular to the main surface 102M of the substrate 102. In embodiments, each of the plurality of interlayer insulating films (e.g., 110, 120, 130, and 140 may include silicon oxide-based materials, such as plasma-enhanced oxide (PEOX), tetraethyl orthosilicate (TEOS), boro TEOS (BTEOS), phosphorous TEOS (PTEOS), boro phospho TESO (BPTEOS), boro silicate glass (BSG), phospho silicate glass (PSG), and boro phospho silicate glass (BPSG). In other embodiments, each of the plurality of interlayer insulating films (e.g., 110, 120, 130, and 140) may include a low-k dielectric film (e.g., a SiOC film or a SiCOH film) having a relatively low dielectric constant of about 2.2 to about 3.0.

The main chip area CA may include a chipping detection area CDA located on an outermost portion closest to the edge area EA. As shown in FIG. 1, in a top view, the chipping detection area CDA may have a tetragonal ring shape continuously extending along an outline of the main chip area CA. In embodiments, the main chip area CA may be located at a position spaced a distance of at least 30 µm apart from an outermost end 100E of the IC device 100 toward the main chip area CA in a lateral direction (e.g., X direction or Y direction) parallel to the main surface 102M of the substrate 102, without being limited thereto.

A chipping detect circuit CDC may be located in the chipping detection area CDA. In a top view, the chipping detect circuit CDC may have a planar shape continuously or intermittently extending along the outline of the main chip area CA in the chipping detection area CDA. The chipping detect circuit CDC may be a circuit configured to detect chipping that may occur when a physical cutting process (e.g., a sawing process) for individualizing the IC device 100 is performed during the process of manufacturing the IC device 100. In embodiments, the chipping detect circuit CDC may be configured to determine that a chipping defect has occurred in the edge area EA when a desired and/or alternatively predetermined signal is not input within a desired and/or alternatively predetermined period of time, and output a signal according to the determination result.

As shown in FIG. 2, the main chip area CA may include a peripheral circuit area PA surrounded by the chipping detection area CDA. The peripheral circuit area PA may be spaced apart in the lateral direction (X direction or Y direction) from the edge area EA with the chipping detection area CDA therebetween and be located adjacent to the chipping detection area CDA. A CMOS transistor, system LSI, an image sensor such as a CIS, MEMS, various active devices, and/or various passive devices may be located in the peripheral circuit area PA.

As shown in FIG. 2, a plurality of transistors TR may be located on the substrate 102 in the peripheral circuit area PA of the main chip area CA. In the peripheral circuit area PA and the chipping detection area CDA, a plurality of wiring structures WS may be located on the substrate 102 and covered by the interlayer insulating films 110, 120, 130, and 140. The plurality of wiring structures WS may include a plurality of wiring patterns (e.g., 122, 132, and 142), and a plurality of conductive contacts (e.g., 114, 124, 134, and 138), each of which passes in the vertical direction (Z direction) through at least a portion of a corresponding one 110, 120, 130, or 140 of the interlayer insulating films 110, 120, 130, and 140. In the chipping detection area CDA, some of the plurality of wiring structures WS may constitute the chipping detect circuit CDC.

The plurality of wiring patterns (e.g., 122, 132, and 142) and the plurality of conductive contacts (e.g., 114, 124, 134, and 138), which are included in the plurality of wiring structures WS, may each include a metal, a conductive metal nitride, or a combination thereof. For example, the plurality of wiring patterns (e.g., 122, 132, and 142) and the plurality of conductive contacts (e.g., 114, 124, 134, and 138) may each include copper (Cu), tungsten (W), molybdenum (Mo), ruthenium (Ru), cobalt (Co), aluminum (Al), manganese (Mn), titanium (Ti), tantalum (Ta), titanium nitride (TiN), tantalum nitride (TaN), tungsten nitride (WN), tungsten carbon nitride (WCN), titanium silicon nitride (TiSiN), tantalum silicon nitride (TaSiN), tungsten silicon nitride (WSiN), cobalt tungsten phosphide (CoWP), cobalt tungsten boron (CoWB), cobalt tungsten boron phosphide (CoWBP), or a combination thereof, without being limited thereto.

As shown in FIG. 1, the edge area EA of the substrate 102 may include a guard ring area GRA, a chipping dam area CPDA, and an outermost edge portion OEA. In a top view, the guard ring area GRA may surround the main chip area CA outside the main chip area CA, the chipping dam area CPDA may surround the main chip area CA and the guard ring area GRA outside the guard ring area GRA, and the outermost edge portion OEA may surround the main chip area CA, the guard ring area GRA, and the chipping dam area CPDA outside the chipping dam area CPDA.

As shown in FIG. 2, a guard ring GR may be located in the guard ring area GRA, and a chipping dam CPD may be located in the chipping dam area CPDA. The guard ring GR may surround the main chip area CA in a top view. The chipping dam CPD may surround the main chip area CA and the guard ring GR in a top view. The chipping dam CPD may be located at a position apart in the lateral direction (e.g., X direction or Y direction) from the main chip area CA with the guard ring GR therebetween. In a top view, each of the guard ring GR and the chipping dam CPD may have a ring shape continuously surrounding the main chip area CA without being cut off.

In embodiments, in the lateral direction (e.g., X direction or Y direction), a width of the chipping dam CPD may be greater than a width of the guard ring GR. For example, the guard ring GR may have a width of about 3 µm to about 6 µm (e.g., a width of about 3.5 µm to about 4.5 µm) in the lateral direction (e.g., X direction or Y direction), and the chipping dam CPD may have a width of about 8 µm to about 14 µm (e.g., a width of about 10 µm to about 12 µm) in the lateral direction (e.g., X direction or Y direction), without being limited thereto.

The IC device 100 may include a planar conductive layer 126 located on the edge area EA of the substrate 102. The planar conductive layer 126 may be located between the substrate 102 and the guard ring GR and between the substrate 102 and the chipping dam CPD. The planar conductive layer 126 may be spaced apart in the vertical direction (Z direction) from the substrate 102 with the interlayer insulating film 110 therebetween, and a bottom surface of the planar conductive layer 126 may be in contact with a top surface of the interlayer insulating film 110. In the edge area EA, the guard ring GR and the chipping dam CPD may be located on the planar conductive layer 126. In embodiments, a bottom surface of a lower guard ring 128 included in each of the guard ring GR and the chipping dam CPD may be in contact with a top surface of the planar conductive layer 126. Here, the bottom surface of the lower guard ring 128 may refer to a surface facing the substrate 102, from among surfaces of the lower guard ring 128. In other embodiments, each of the guard ring GR and the chipping dam CPD may be configured to be connected to the planar conductive layer 126 through at least one conductive contact plug.

As shown in FIG. 2, each of the guard ring GR and the chipping dam CPD may include the lower guard ring 128 and an upper guard ring structure UGS. In each of the guard ring GR and the chipping dam CPD, the lower guard ring 128 and the upper guard ring structure UGS may be connected to each other. The upper guard ring structure UGS may be spaced apart in the vertical direction (Z direction) from the substrate 102 with the lower guard ring 128 therebetween.

The upper guard ring structure UGS may include a plurality of upper guard rings (e.g., 136A, 136B, 136C, and 136D) and a plurality of guard via contacts 137. The plurality of upper guard rings (e.g., 136A, 136B, 136C, and 136D) may overlap each other in the vertical direction (Z direction). Each of the plurality of guard via contacts 137 may be located between a pair of upper guard rings that are adjacent to each other in the vertical direction (Z direction), from among the plurality of upper guard rings (e.g., 136A, 136B, 136C, and 136D). For example, the plurality of guard via contacts 137 may be respectively located between a pair of upper guard rings 136A and 136B, between a pair of upper guard rings 136B and 136C, and between a pair of upper guard rings 136C and 136D. Each of the plurality of guard via contacts 137 may be connected to a pair of upper guard rings that are adjacent to each other in the vertical direction (Z direction), from among the upper guard rings 136A, 136B, 136C, and 136D. In each of the guard ring GR and the chipping dam CPD, from among the plurality of upper guard rings (e.g., 136A, 136B, 136C, and 136D), the upper guard ring 136A closest to the lower guard ring 128 may be in contact with a top surface of the lower guard ring 128.

In each of the guard ring GR and the chipping dam CPD, a length of the lower guard ring 128 in the vertical direction (Z direction) may be greater than a length in the vertical direction (Z direction) of each of the plurality of upper guard rings (e.g., 136A, 136B, 136C, and 136D). The lower guard ring 128 included in each of the guard ring GR and the chipping dam CPD may have a first length in the vertical direction (Z direction), and each of the plurality of upper guard rings (e.g., 136A, 136B, 136C, and 136D) included in each of the guard ring GR and the chipping dam CPD may have a length less than the first length in the vertical direction (Z direction). In embodiments, respective lengths of the plurality of upper guard rings (e.g., 136A, 136B, 136C, and 136D) in the vertical direction (Z direction) may be equal or similar to each other. In other embodiments, at least some of the plurality of upper guard rings (e.g., 136A, 136B, 136C, and 136D) may have different lengths from each other in the vertical direction (Z direction). As used herein, similarity in size or length between different components means a 10 % deviation or less. For example, when a length of a first component is 10 µm and a length of a second component is similar to that of the first component, it means that the length of the second component is in a range of about 9 µm to about 11 µm.

In embodiments, in each of the guard ring GR and the chipping dam CPD, a length of the lower guard ring 128 in the vertical direction (Z direction) may be greater than a length of the upper guard ring structure UGS in the vertical direction (Z direction). In other embodiments, unlike shown in FIG. 2, in each of the guard ring GR and the chipping dam CPD, a length of the lower guard ring 128 in the vertical direction (Z direction) may be less than a length of the upper guard ring structure UGS in the vertical direction (Z direction). In still other embodiments, in each of the guard ring GR and the chipping dam CPD, a length of the lower guard ring 128 in the vertical direction (Z direction) may be substantially equal to a length of the upper guard ring structure UGS in the vertical direction (Z direction).

FIG. 2 illustrates an example in which the upper guard ring structure UGS includes four upper guard rings 136A, 136B, 136C, and 136D overlapping each other in the vertical direction (Z direction), but inventive concepts are not limited thereto. The upper guard ring structure UGS may include at least one upper guard ring, and the number of upper guard rings included in the upper guard ring structure UGS is not specifically limited. For example, the upper guard ring structure UGS may include one, two, three, five, or more upper guard rings.

As shown in FIG. 2, the upper guard ring structure UGS included in the guard ring GR may be spaced apart from the upper guard ring structure UGS included in the chipping dam CPD in the lateral direction (X direction or Y direction). The lower guard ring 128 included in the guard ring GR may be integrally connected to the lower guard ring 128 included in the chipping dam CPD. Thus, the guard ring GR may be connected to the chipping dam CPD through the lower guard ring 128.

The guard ring GR and the chipping dam CPD may be located at vertical levels (or a first vertical level), which are spaced substantially the same distance apart in the vertical direction (Z direction) from the main surface 102M of the substrate 102. A distance in the vertical direction (Z direction) from the main surface 102M of the substrate 102 to a bottom surface of the guard ring GR may be substantially equal to a distance in the vertical direction (Z direction) from the main surface 102M of the substrate 102 to the chipping dam CPD.

The planar conductive layer 126, the lower guard ring 128, the plurality of upper guard rings (e.g., 136A, 136B, 136C, and 136D), and the plurality of guard via contacts 137 may each include a conductive material. In embodiments, the planar conductive layer 126, the lower guard ring 128, the plurality of upper guard rings (e.g., 136A, 136B, 136C, and 136D), and the plurality of guard via contacts 137 may include the same conductive material. In other embodiments, at least some of the planar conductive layer 126, the lower guard ring 128, the plurality of upper guard rings (e.g., 136A, 136B, 136C, and 136D), and the plurality of guard via contacts 137 may include different conductive materials from each other. In embodiments, the planar conductive layer 126, the lower guard ring 128, the plurality of upper guard rings (e.g., 136A, 136B, 136C, and 136D), and the plurality of guard via contacts 137 may each include a metal, a conductive metal nitride, or a combination thereof. For example, the plurality of wiring patterns (e.g., 122, 132, and 142) and the plurality of conductive contacts (e.g., 114, 124, 134, and 138) may each include Cu, W, Mo, Ru, Co, Al, Mn, Ti, Ta, TiN, TaN, WN, WCN, TiSiN, TaSiN, WSiN, CoWP, CoWB, CoWBP, or a combination thereof, without being limited thereto.

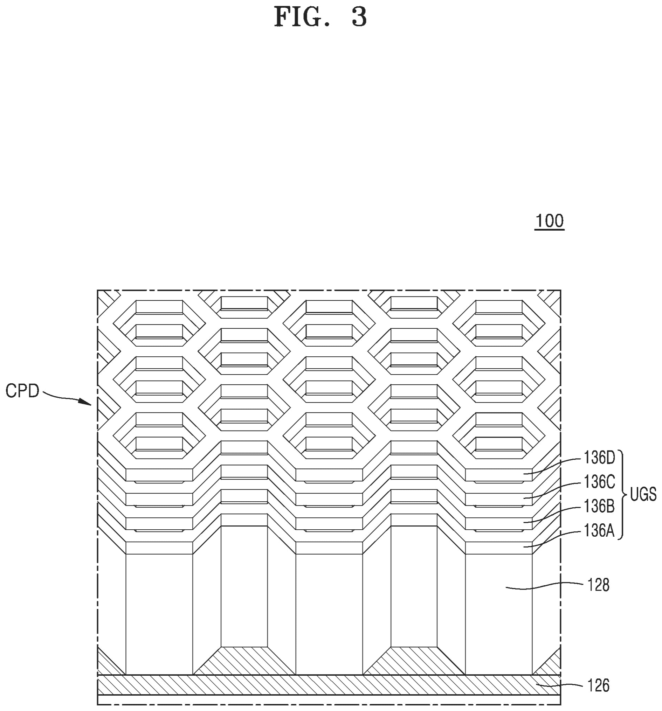

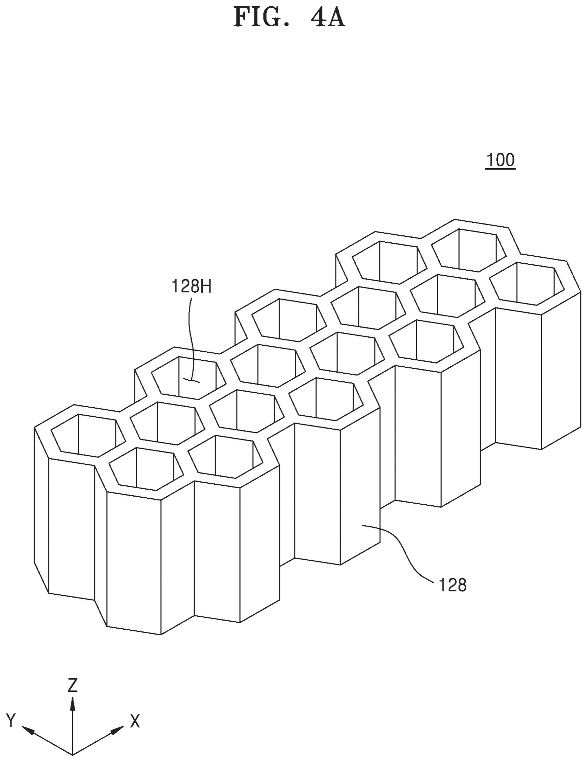

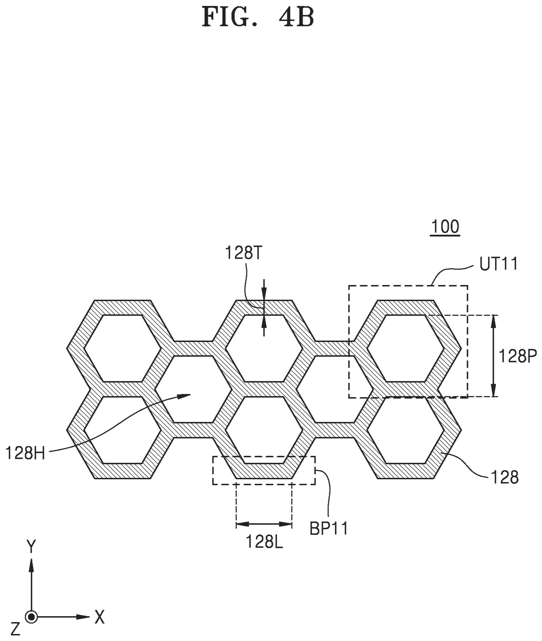

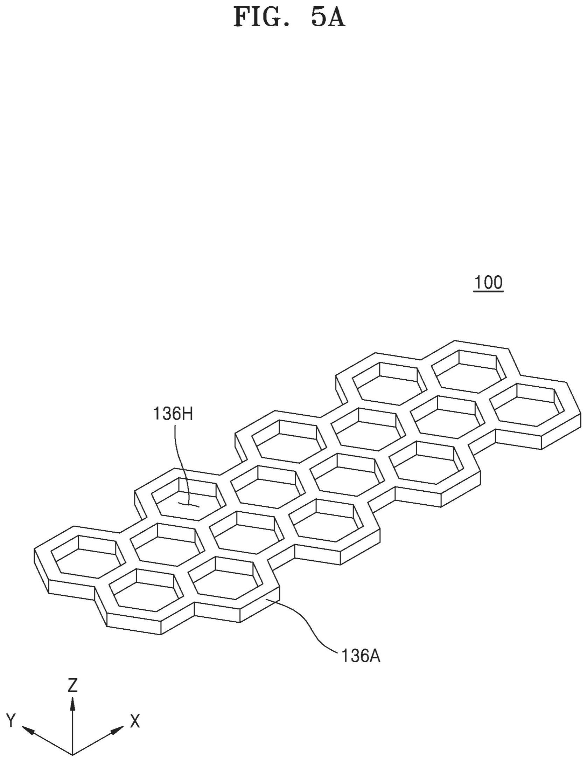

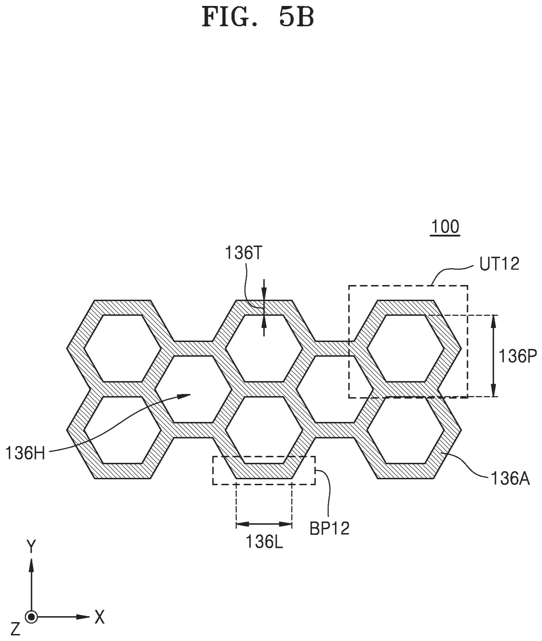

FIG. 3 is a schematic perspective view of a partial region "EX1" of FIG. 2. FIG. 4A is a schematic perspective view of a partial region of a lower guard ring 128, and FIG. 4B is a plan view of a partial view of the lower guard ring 128. FIG. 5A is a schematic perspective view of a partial region of an upper guard ring 136A, which is one of a plurality of upper guard rings (e.g., 136A, 136B, 136C, and 136D) included in the an upper guard ring structure UGS, and FIG. 5B is a plan view of a partial region of the upper guard ring 136A. Hereinafter, for brevity, a configuration of the upper guard ring 136A, which is one of the plurality of upper guard rings (e.g., 136A, 136B, 136C, and 136D), is described in detail; however, it should be understood that the other upper guard rings 136B, 136C, and 136D also have substantially the same configuration as the upper guard ring 136A.

Referring to FIGS. 3, 4A, and 4B, in a top view, the lower guard ring 128 included in each of a guard ring GR and a chipping dam CPD may include a mesh structure defining a plurality of first polygonal vertical holes 128H. As used herein, the mesh structure of the lower guard ring 128 may be referred to as a first mesh structure. In a top view, each of the plurality of first polygonal vertical holes 128H included in the lower guard ring 128 may include a hole having a hexagonal shape. The lower guard ring 128 may have a network structure in which a plurality of first unit structures each having a honeycomb shape are integrally connected to each other.

Referring to FIG. 4B, the mesh structure included in the lower guard ring 128 may include a plurality of first polygonal units UT11, which define the plurality of first polygonal vertical holes 128H and are integrally connected to each other. The plurality of first polygonal units UT11 included in the lower guard ring 128 may be arranged in the lateral direction (e.g., X direction or Y direction) at a pitch 128P selected in a range of about 0.5 µm to about 3.0 µm, for example, a pitch 128P selected in a range of about 0.9 µm to about 1.8 µm. Each of the plurality of first polygonal units UT11 included in the lower guard ring 128 may include a plurality of bar components BP11 defining the first polygonal vertical hole 128H. In embodiments, a first thickness 128T in a lateral direction of each of the plurality of bar components BP11 may be selected in a range of about 0.05 µm to about 0.4 µm, for example, a range of about 0.10 µm to about 0.15 µm, without being limited thereto. In embodiments, a length 128L in the lateral direction of each of the plurality of bar components BP11 may be selected in a range of about 0.3 µm to about 2.0 µm, without being limited thereto. In embodiments, an angle formed by two bar components BP11, which are adjacent to and in contact with each other, from among the plurality of bar components BP11, may be in a range of about 20° to about 140°, without being limited thereto.

Referring to FIGS. 3, 5A, and 5B, in a top view, each of the plurality of upper guard rings (e.g., 136A, 136B, 136C, and 136D) included in each of the guard ring GR and the chipping dam CPD may include a mesh structure defining a plurality of second polygonal vertical holes 136H. As used herein, the mesh structure of each of the plurality of upper guard rings (e.g., 136A, 136B, 136C, and 136D) may be referred to as a second mesh structure. In a top view, each of the plurality of second polygonal vertical holes 136H included in each of the plurality of upper guard rings (e.g., 136A, 136B, 136C, and 136D) may include a hole having a hexagonal shape. Each of the plurality of upper guard rings (e.g., 136A, 136B, 136C, and 136D) may have a network structure in which a plurality of second unit structures each having a honeycomb shape are integrally connected to each other.

Referring to FIG. 5B, the mesh structure included in each of the plurality of upper guard rings (e.g., 136A, 136B, 136C, and 136D) may include a plurality of second polygonal units UT12,which define the plurality of second polygonal vertical holes 136H and be integrally connected to each other. The plurality of second polygonal units UT12 included in each of the plurality of upper guard rings (e.g., 136A, 136B, 136C, and 136D) may be arranged at a pitch 136P selected in a range of about 0.5 µm to about 3.0 µm (e.g., a pitch 136P selected in a range of about 0.9 µm to about 1.8 µm) in the lateral direction (e.g., X direction or Y direction). Each of the plurality of second polygonal units UT12 included in each of the plurality of upper guard rings (e.g., 136A, 136B, 136C, and 136D) may include a plurality of bar components BP12 defining the second polygonal vertical hole 136H. In embodiments, a second thickness 136T in the lateral direction of each of the plurality of bar components BP12 may be selected in a range of about 0.05 µm to about 0.8 µm, for example, a range of about 0.10 µm to about 0.30 µm, without being limited thereto. In embodiments, a length 136L in the lateral direction of each of the plurality of bar components BP12 may be selected in a range of about 0.3 µm to about 2.0 µm, without being limited thereto. In embodiments, an angle formed by two bar components BP12, which are adjacent to and in contact with each other, from among the plurality of bar components BP12, may be in a range of about 20° to about 140°, without being limited thereto.

In embodiments, the first thickness (refer to 128T in FIG. 4B) of each of the plurality of bar components BP11 included in the lower guard ring 128 may be substantially equal to the second thickness (refer to 136T in FIG. 5B) of each of the plurality of bar components BP12 included in each of the plurality of upper guard rings (e.g., 136A, 136B, 136C, and 136D). In other embodiments, the first thickness 128T may be different from the second thickness 136T. In an example, the first thickness 128T may be less than the second thickness 136T. In another example, the first thickness 128T may be greater than the second thickness 136T. In embodiments, a difference between the first thickness 128T and the second thickness 136T may be within ± 50 %. For example, the second thickness 136T may be selected in a range between a value 50% less than the first thickness 128T and a value 50% greater than the first thickness 128T.

In embodiments, in the lower guard ring 128, the network structure in which the plurality of first unit structures each having a honeycomb shape are integrally connected to each other may have a constant density regardless of a distance from the main chip area CA in the lateral direction. In an example for implementing a structure in which the lower guard ring 128 has the constant density regardless of the distance from the main chip area CA in the lateral direction, the pitch (refer to 128P in FIG. 4B) and the first thickness (refer to 128T in FIG. 4B) of the lower guard ring 128 shown in FIGS. 4A and 4B may be configured to be constant regardless of the distance from the main chip area CA in the lateral direction in the lower guard ring 128.

In other embodiments, in the lower guard ring 128, the network structure in which the plurality of first unit structures each having a honeycomb shape are integrally connected to each other may have a variable density toward the main chip area CA in the lateral direction. For example, in the lower guard ring 128, the network structure in which the plurality of first unit structures each having the honeycomb shape are integrally connected to each other may have a density that gradually increases toward the main chip area CA in the lateral direction. In an example for implementing a structure in which the lower guard ring 128 has the variable density toward the main chip area CA, the pitch 128P of the lower guard ring 128 shown in FIG. 4B may be constant depending on a position of the lower guard ring 128, and the first thickness 128T of the lower guard ring 128 may be configured to gradually increase toward the main chip area CA in the lateral direction. In another example for implementing a structure in which the lower guard ring 128 has the variable density toward the main chip area CA, the pitch 128P of the lower guard ring 128 shown in FIG. 4B may be gradually reduced toward the main chip area CA in the lateral direction, and the first thickness 128T of the lower guard ring 128 may be configured to be constant depending on a position of the lower guard ring 128.

In embodiments, in each of the plurality of upper guard rings (e.g., 136A, 136B, 136C, and 136D) included in the upper guard ring structure UGS, a network structure in which the plurality of second unit structures each having a honeycomb shape are integrally connected to each other may have a constant density regardless of a distance from the main chip area CA in the lateral direction. In an example for implementing a structure in which each of the plurality of upper guard rings (e.g., 136A, 136B, 136C, and 136D) has the constant density regardless of the distance from the main chip area CA in the lateral direction, the pitch (refer to 136P in FIG. 5B) and the second thickness (refer to 136T in FIG. 5B) of the plurality of upper guard rings (e.g., 136A, 136B, 136C, and 136D) may be configured to be constant regardless of the distance from the main chip area CA in the lateral direction in the plurality of upper guard rings (e.g., 136A, 136B, 136C, and 136D).

In other embodiments, in each of the plurality of upper guard rings (e.g., 136A, 136B, 136C, and 136D) included in the upper guard ring structure UGS, the network structure in which the plurality of second unit structures each having the honeycomb shape are integrally connected to each other may have a variable density toward the main chip area CA in the lateral direction. For example, in each of the plurality of upper guard rings (e.g., 136A, 136B, 136C, and 136D) included in the upper guard ring structure UGS, the network structure in which the plurality of second unit structures each having a honeycomb shape are integrally connected to each other may have a density that gradually increases toward the main chip area CA in the lateral direction. In an example for implementing a structure in which the plurality of upper guard rings (e.g., 136A, 136B, 136C, and 136D) have the variable density in a direction toward the main chip area CA, the pitch 136P of the plurality of upper guard rings (e.g., 136A, 136B, 136C, and 136D) may be constant depending on a position of each of the plurality of upper guard rings (e.g., 136A, 136B, 136C, and 136D), and the second thickness 136T of the plurality of upper guard rings (e.g., 136A, 136B, 136C, and 136D) may be configured to gradually increase toward the main chip area CA in the lateral direction. In another example for implementing a structure in which the plurality of upper guard rings (e.g., 136A, 136B, 136C, and 136D) have the variable density in the direction toward the main chip area CA, the pitch 136P of the plurality of upper guard rings (e.g., 136A, 136B, 136C, and 136D) may be gradually reduced toward the main chip area CA in the lateral direction, and the second thickness 136T of the plurality of upper guard rings (e.g., 136A, 136B, 136C, and 136D) may be configured to be constant depending on a position of each of the plurality of upper guard rings (e.g., 136A, 136B, 136C, and 136D).

In the IC device 100, the chipping dam CPD may limit and/or prevent damage (e.g., cracks, chipping, and breakage), which may occur in a physical cutting process (e.g., a sawing process) for individualizing the IC device 100, from propagating to the main chip area CA during the process of manufacturing the IC device 100. The guard ring GR may limit and/or prevent cracks, which may occur in the physical cutting process (e.g., the sawing process) for individualizing the IC device 100, from propagating to the main chip area CA during the process of manufacturing the IC device 100. Also, the guard ring GR and the chipping dam CPD may limit and/or prevent moisture from penetrating from the outside of the IC device 100 into a chip. Thus, unit devices in the main chip area CA may be limited and/or prevented from being damaged or malfunctioning due to moisture from the outside.

As shown in FIG. 2, a plurality of upper guard via contacts 139 passing through a portion of the interlayer insulating film 130 in a vertical direction (Z direction) may be located on the guard ring GR and the chipping dam CPD in the edge area EA. The plurality of upper guard via contacts 139 may be in contact with the upper guard ring 136D, which is an uppermost one of the plurality of upper guard rings (e.g., 136A, 136B, 136C, and 136D), and be connected to the upper guard ring structure UGS. An upper guard wring layer 146 may be located on the plurality of upper guard via contacts 139. The upper guard wiring layer 146 may be in contact with a top surface of each of the plurality of upper guard via contacts 139 and the interlayer insulating film 130. The upper guard wiring layer 146 may be connected to the upper guard ring structure UGS through the plurality of upper guard via contacts 139.

The plurality of wiring structures WS located in the main chip area CA may include a plurality of wiring patterns (e.g., 122, 132, and 142), which are located at substantially the same vertical level as each of the guard ring GR and the chipping dam CPD located in the edge area EA. The plurality of upper guard via contacts 139 located in the edge area EA and a plurality of conductive contacts 138 located in the main chip area CA may be located at substantially the same vertical level from the main surface 102M of the substrate 102. The upper guard wiring layer 146 located in the edge area EA and the wiring pattern 142 located in the main chip area CA may be located at substantially the same vertical level from the main surface 102M of the substrate 102.

As shown in FIGS. 1 and 2, a moat structure MS may be located between the guard ring GR and the chipping dam CPD in the edge area EA of the substrate 102. In a top view, the moat structure MS may have a ring shape continuously surrounding the main chip area CA and the guard ring GR without being cut off. However, inventive concepts are not limited thereto. The moat structure MS may have a shape intermittently extending in a ring-shaped separation space located between the guard ring GR and the chipping dam CPD in a lengthwise direction of the separation space.

The moat structure MS may include a metal moat pattern 154 having a substantially U cross-sectional shape defining an inner space and an insulating liner 156 conformally covering an inner surface of the metal moat pattern 154 in the inner space defined by the metal moat pattern 154, and the insulating liner 156 may be in contact with the inner surface of the metal moat pattern 154. The moat structure MS may be located between the plurality of upper guard rings (e.g., 136A, 136B, 136C, and 136D) included in the guard ring GR and the plurality of upper guard rings (e.g., 136A, 136B, 136C, and 136D) included in the chipping dam CPD and pass through a portion of the lower guard ring 128 included in each of the guard ring GR and the chipping dam CPD in the vertical direction (Z direction). The moat structure MS may pass through the upper guard wiring layer 146 in the vertical direction (Z direction).

An outer surface of the metal moat pattern 154 of the moat structure MS may include a portion in contact with the lower guard ring 128 included in each of the guard ring GR and the chipping dam CPD, a portion in contact with the plurality of upper guard rings (e.g., 136A, 136B, 136C, and 136D) included in each of the guard ring GR and the chipping dam CPD, and a portion in contact with the upper guard wiring layer 146. The lower guard ring 128 included in each of the guard ring GR and the chipping dam CPD may be in contact with a bottom surface of the metal moat pattern 154 of the moat structure MS, and the plurality of upper guard rings (e.g., 136A, 136B, 136C, and 136D) included in each of the guard ring GR and the chipping dam CPD may be in contact with an outer sidewall of the metal moat pattern 154 of the moat structure MS. The lower guard ring 128 included in the guard ring GR and the lower guard ring 128 included in the chipping dam CPD may be in contact with a bottom surface of the moat structure MS between the substrate 102 and the moat structure MS. The lower guard ring 128 included in the guard ring GR may be integrally connected to the lower guard ring 128 included in the chipping dam CPD between the substrate 102 and the moat structure MS.

The metal moat pattern 154 of the moat structure MS may include a metal-containing film. In embodiments, the metal moat pattern 154 may include a metal, a conductive metal nitride, or a combination thereof. For example, the metal moat pattern 154 may include Cu, W, Mo, Ru, Co, Al, Mn, Ti, Ta, TiN, TaN, WN, WCN, TiSiN, TaSiN, WSiN, CoWP, CoWB, CoWBP, or a combination thereof, without being limited thereto. The insulating liner 156 of the moat structure MS may include a silicon nitride film, a silicon oxide film, a silicon carbonitride (SiCN) film, a silicon boronitride (SiBN) film, a silicon boron carbonitride (SiBCN) film, a silicon oxynitride (SiON) film, a silicon oxycarbide (SiOC) film, a silicon oxycarbonitride (SiOCN) film, a silicon oxyfluoride (SiOF) film, or a combination thereof, without being limited thereto.

A vertical level of a top surface of the metal moat pattern 154 of the moat structure MS, which is farthest from the substrate 102, may be farther from the substrate 102 than a vertical level of a top surface of each of the guard ring GR and the chipping dam CPD, which is farthest from the substrate 102. Accordingly, during the process of manufacturing the IC device 100, damage such as cracks, chipping, and breakage, which may occur when a physical cutting process (e.g., a sawing process) for individualizing the IC device 100, may be effectively limited and/or prevented by the moat structure MS from propagating to the main chip area CA at a higher vertical level than a top surface of each of the guard ring GR and the chipping dam CPD.

As shown in FIG. 1, the guard ring GR may be located at a position adjacent to a boundary between the main chip area CA and the edge area EA in the edge area EA, and the chipping detect circuit CDC may be located at a position adjacent to a boundary between the main chip area CA and the edge area EA in the main chip area CA. In a top view, the chipping detect circuit CDC may be surrounded by the guard ring GR.

A guard member (e.g., an additional guard ring or guard structure) configured to prevent defects (e.g., cracks, chipping, and breakage), which may occur when a physical cutting process (e.g., a sawing process) for individualizing the IC device 100 is performed, from propagating to the main chip area CA during the process of manufacturing the IC device 100 may not be located between the chipping detect circuit CDC and the guard ring GR in the main chip area CA. Accordingly, when the IC device 100 is manufactured, processes of manufacturing an additional guard structure located on the main chip area CA may be omitted, and thus, the process of manufacturing the IC device 100 may be simplified. In addition, an area required to arrange the additional guard structure in the IC device 100 may be reduced, which may reduce an area occupied by the IC device 100 and help integrate more functions capable of improving the performance of the IC device 100. Therefore, the performance of the IC device 100 may improve, and the sizes of products including the IC device 100 may be reduced.

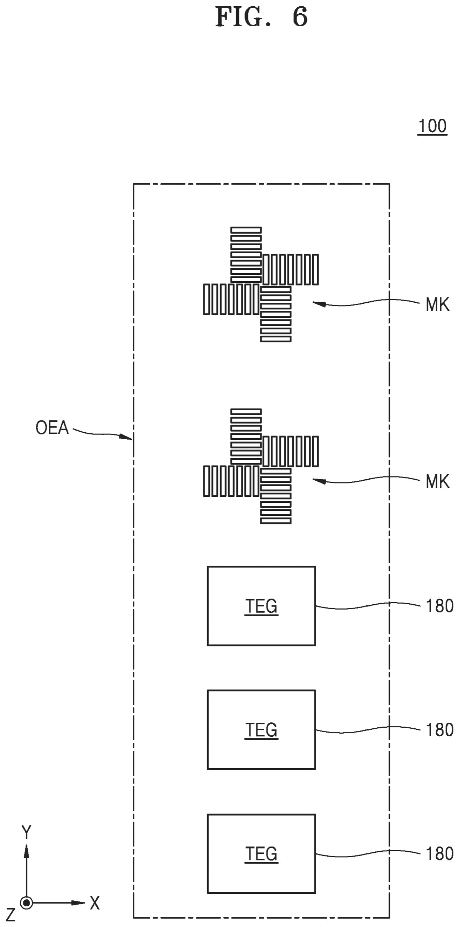

FIG. 6 is a schematic plan view of an outermost edge portion OEA of an IC device 100.

Referring to FIG. 6, a plurality of measurement marks MK and a plurality of test element groups (TEGs) 180 may be located on an outermost edge portion OEA farthest from a main chip area CA, of an edge area EA of a substrate 102. The outermost edge portion OEA may be an outer region of a chipping dam CPD in the edge area EA. In a top view, the outermost edge portion OEA may be a region spaced apart in a lateral direction (e.g., X direction or Y direction) from a guard ring area GRA and a moat structure MS with a chipping dam area CPDA therebetween.

A plurality of measurement marks MK may be located at an arbitrary vertical level on the substrate 102. For example, the plurality of measurement marks MK may be located on a top surface of at least one interlayer insulating film selected from a plurality of interlayer insulating films (e.g., 110, 120, 130, and 140). In embodiments, at least some of the plurality of measurement marks MK may be used as overlay keys configured to measure overlays between feature patterns formed in the main chip area CA during a process of manufacturing the IC device 100. In other embodiments, at least some of the plurality of measurement marks MK may be used as an alignment key configured to align a specific area of an exposure device with a lower structure when a photolithography process of forming feature patterns on the lower structure in the main chip area CA during the process of manufacturing the IC device 100. As used herein, the term "photolithography process" refers to a process of performing exposure by using a reticle or photomask having a pattern of an image to be transferred onto a lower structure (e.g., a wafer) to transfer a desired image pattern on the lower structure, and developing a transferred image. A specific shape of each of the plurality of measurement marks MK shown in FIG. 6 is provided for brevity, and a shape of each of the plurality of measurement marks MK may be variously modified and changed as needed within the scope of inventive concepts.

Each of the plurality of TEGs 180 (e.g., circuit structures) may be used to determine whether the IC device 100 is operating. In embodiments, each of the plurality of TEGs 180 may include a portion passing in a vertical direction through the interlayer insulating film 140, which is an uppermost one of the plurality of interlayer insulating films (e.g., 110, 120, 130, and 140). The plurality of TEGs 180 may be configured to be respectively connected to a plurality of wiring structures (refer to WS in FIG. 2).

As shown in FIG. 2, the IC device 100 may include a redistribution structure RDS located on the plurality of wiring structures WS on the main chip area CA. The redistribution structure RDS may include a plurality of redistribution layers 152 configured to be connected to at least one wiring pattern (e.g., 122, 132, and 142) included in the plurality of wiring structures WS. At least some of the plurality of redistribution layers 152 may be used as a path configured to connect the plurality of wiring structures WS located in the main chip area CA to an external circuit. A metal moat pattern 154 included in the moat structure MS and at least some of the plurality of redistribution layers 152 included in the redistribution structure RDS may be arranged at the same vertical level on the substrate 102.

The plurality of redistribution layers 152 and the plurality of TEGs 180 may include a metal, a conductive metal nitride, or a combination thereof. In embodiments, the plurality of redistribution layers 152, the metal moat pattern 154, and the plurality of TEGs 180 may include the same material. For example, the plurality of redistribution layers 152, the metal moat pattern 154, and the plurality of TEGs 180 may include the same material selected from Cu, W, Mo, Ru, Co, Al, Mn, Ti, Ta, TiN, TaN, WN, WCN, TiSiN, TaSiN, WSiN, CoWP, CoWB, CoWBP, and a combination thereof.

As shown in FIG. 2, the insulating liner 156 may include a portion forming a portion of the moat structure MS in the edge area EA, a portion covering the plurality of redistribution layers 152 forming the redistribution structure RDS in the main chip area CA, and a portion covering a top surface of the interlayer insulating film 140, which is an uppermost one of the plurality of interlayer insulating films (e.g., 110, 120, 130, and 140) in the main chip area CA and the edge area EA.

In the main chip area CA and the edge area EA, the insulating liner 156 may be covered by an outermost insulating film 160. A portion of the outermost insulating film 160 may cover the insulating liner 156 in an inner space defined by the metal moat pattern 154 of the moat structure MS. The outermost insulating film 160 may protect a surface of the IC device 100 and prevent the corrosion and oxidation of the IC device 100. The outermost insulating film 160 may include an insulating polymer. For instance, the outermost insulating film 160 may include photosensitive polyimide, without being limited thereto.

The IC device 100 described with reference to FIGS. 1 to 6 may include the guard ring GR and the chipping dam CPD, which are located on the edge area EA surrounding the main chip area CA of the substrate 102 and sequentially surround the main chip area CA. Each of the guard ring GR and the chipping dam CPD may include the lower guard ring 128 and the upper guard ring structure UGS, which overlap each other in the vertical direction (Z direction) and are connected to each other. Each of the lower guard ring 128 and the plurality of upper guard rings (e.g., 136A, 136B, 136C, and 136D) included in the upper guard ring structure UGS may include a mesh structure defining a polygonal vertical hole. In embodiments, as shown in FIGS. 3, 4A, 4B, 5A, and 5B, each of the lower guard ring 128 and the plurality of upper guard rings (e.g., 136A, 136B, 136C, and 136D) form a network structure in which a plurality of unit structures each having a honeycomb shape are integrally connected to each other. Accordingly, during the process of manufacturing the IC device 100, when a physical cutting process (e.g., a sawing process) for individualizing the IC device 100 is performed, physical damage (e.g., cracks, chipping, and breakage) may occur from a cut surface. In this case, even when the physical damage propagates to the chipping dam CPD and/or the guard ring GR, energy causing the physical damage may be easily dissipated due to the lower guard ring 128 and the plurality of upper guard rings (e.g., 136A, 136B, 136C, and 136D), which are included in the chipping dam CPD and/or the guard ring GR and each have a honeycomb-shaped mesh structure. Therefore, in the IC device 100, the dissipation ability of energy causing the physical damage transmitted from the outside may be enhanced by the lower guard ring 128 and the plurality of upper guard rings (e.g., 136A, 136B, 136C, and 136D), which constitute the guard ring GR and the chipping dam CPD. Thus, the propagation of cracks, chipping, and breakage that may occur during a physical cutting process for individualizing the IC device 100 may be blocked, thereby providing the IC device 100 with improved reliability and productivity.

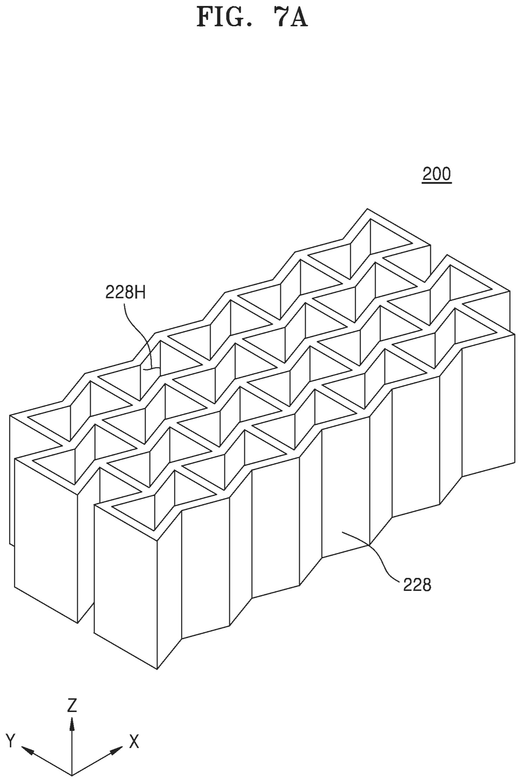

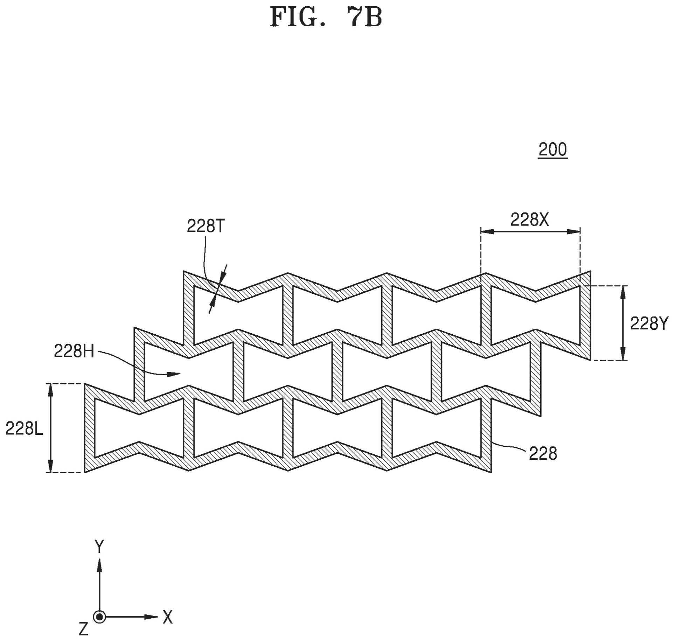

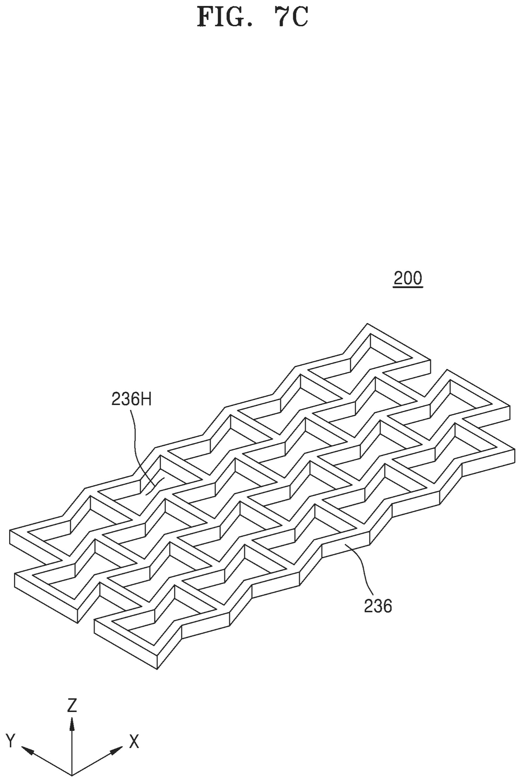

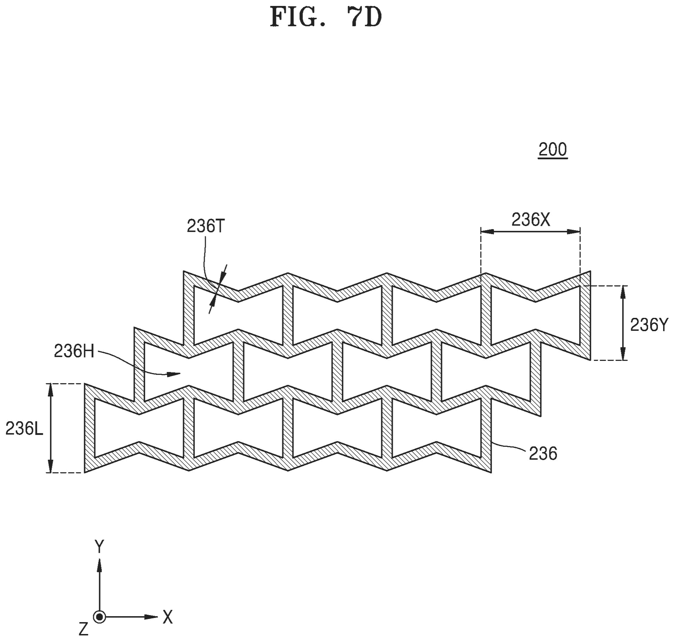

FIGS. 7A to 7D are diagrams of an IC device 200 according to other embodiments, wherein FIG. 7A is a schematic perspective view of a partial region of a lower guard ring 228 included in the IC device 200, FIG. 7B is a plan view of a partial region of the lower guard ring 228, FIG. 7C is a schematic perspective view of a partial region of an upper guard ring 236 included in the IC device 200, and FIG. 7D is a plan view of a partial region of the upper guard ring 236.

Referring to FIGS. 7A to 7D, the IC device 200 may substantially have the same configuration as the IC device 100 described with reference to FIGS. 1 to 6. However, in the IC device 200, each of the guard ring (refer to GR in FIG. 2) and the chipping dam (refer to CPD in FIG. 2) may have a structure in which a lower guard ring (refer to 128 in FIG. 2) is replaced by the lower guard ring 228 shown in FIGS. 7A and 7B and each of the plurality of upper guard rings (refer to 136A, 136B, 136C, and 136D in FIG. 2) included in the upper guard ring structure (refer to UGS in FIG. 2) is replaced by the upper guard ring 236 shown in FIGS. 7C and 7D.

The lower guard ring 228 and the upper guard ring 236 may respectively and substantially have the same configurations as the lower guard ring 128 and the upper guard ring 136A, which have been described with reference to FIGS. 2 to 5B. However, a plurality of first polygonal vertical holes 228H included in the lower guard ring 228 and a plurality of second polygonal vertical holes 236H included in the upper guard ring 236 may each include a hole having a re-entrant honeycomb shape in a top view. As used herein, a re-entrant honeycomb shape may also be referred to as a bow-tie shape. Each of the plurality of first polygonal vertical holes 228H and the plurality of second polygonal vertical holes 236H may have a network structure in which a plurality of unit structures each having a re-entrant honeycomb shape are integrally connected to each other.

In embodiments, as shown in FIG. 7B, a first thickness 228T in a lateral direction of each of a plurality of bar components defining the first polygonal vertical hole 228H in the lower guard ring 228 may be selected in a range of about 0.05 µm to about 0.4 µm, for example, a range of about 0.10 µm to about 0.15 µm, without being limited thereto. In embodiments, a length 228L in the lateral direction of each of the plurality of bar components defining the first polygonal vertical hole 228H in the lower guard ring 228 may be selected in a range of about 0.3 µm to about 2.0 µm, without being limited thereto.

In embodiments, as shown in FIG. 7D, a second thickness 236T in the lateral direction of each of a plurality of bar components defining the plurality of second polygonal vertical holes 236H in the upper guard ring 236 may be selected in a range of about 0.05 µm to about 0.8 µm, for example, a range of about 0.10 µm to about 0.30 µm, without being limited thereto. In embodiments, a length 236L in the lateral direction of each of the plurality of bar components defining the plurality of second polygonal vertical holes 236H in the upper guard ring 236 may be selected in a range of about 0.3 µm to about 2.0 µm, without being limited thereto.

In embodiments, the first thickness (refer to 228T in FIG. 7B) of each of the plurality of bar components included in the lower guard ring 228 may substantially be equal to the second thickness (refer to 236T in FIG. 7D) of each of the plurality of bar components included in each of the plurality of upper guard rings 236. In other embodiments, the first thickness 228T and the second thickness 236T may be different from each other. In an example, the first thickness 228T may be less than the second thickness 236T. In another example, the first thickness 228T may be greater than the second thickness 236T. In embodiments, a difference between the first thickness 228T and the second thickness 236T may be within ± 50 %. For example, the second thickness 236T may be selected in a range between a value 50% less than the first thickness 228T and a value 50% greater than the first thickness 228T.

In embodiments, in the lower guard ring 228, a network structure in which a plurality of first unit structures each having a honeycomb shape are integrally connected to each other may have a constant density regardless of a distance from the main chip area CA in the lateral direction. In an example for implementing a structure in which the lower guard ring 228 has the constant density regardless of the distance from the main chip area CA in the lateral direction, the lower guard ring 228 shown in FIG. 7B may be configured such that a pitch 228X in a first lateral direction (X direction) and a pitch 228Y and the first thickness 228T in a second lateral direction (Y direction) are constant regardless of the distance from the main chip area CA in the lateral direction in the lower guard ring 228.

In other embodiments, in the lower guard ring 228, a network structure in which the plurality of first unit structures each having a re-entrant honeycomb shape are integrally connected to each other may have a variable density toward the main chip area CA in the lateral direction. For example, in the lower guard ring 228, the network structure in which the plurality of first unit structures each having the re-entrant honeycomb shape are integrally connected to each other may have a density that gradually increases toward the main chip area CA in the lateral direction. In an example for implementing a structure in which the lower guard ring 228 has the variable density toward the main chip area CA, the pitch 228X of the lower guard ring 228 in the first lateral direction (X direction) and the pitch 228Y of the lower guard ring 228 in the second lateral direction (Y direction) may be configured to be constant depending on a position of the lower guard ring 228, and the first thickness 228T of the lower guard ring 228 may be configured to gradually increase toward the main chip area CA in the lateral direction. In another example for implementing a structure in which the lower guard ring 228 has the variable density toward the main chip area CA, the pitch 228X of the lower guard ring 228 in the first lateral direction (X direction) and the pitch 228Y of the lower guard ring 228 in the second lateral direction (Y direction) may be configured to be gradually reduced toward the main chip area CA, and the first thickness 228T of the lower guard ring 228 may be configured to be constant depending on a position of the lower guard ring 228.

In embodiments, in the upper guard ring 236, a network structure in which a plurality of second unit structures each having a re-entrant honeycomb shape are integrally connected to each other may have a constant density regardless of a distance from the main chip area CA in the lateral direction. In an example for implementing a structure in which the upper guard ring 236 has the constant density regardless of the distance from the main chip area CA in the lateral direction, a pitch 236X of the upper guard ring 236 in the first lateral direction (X direction) and a pitch 236Y and the second thickness (refer to 236T in FIG. 7D) of the upper guard ring 236 in the second lateral direction (Y direction) may be configured to be constant regardless of the distance from the main chip area CA in the lateral direction in the upper guard ring 236.

In other embodiments, in the upper guard ring 236, the network structure in which the plurality of second unit structures each having the re-entrant honeycomb shape are integrally connected to each other may have a variable density toward the main chip area CA in the lateral direction.. For example, in the upper guard ring 236, the network structure in which the plurality of second unit structures each having the re-entrant honeycomb shape are integrally connected to each other may have a density that gradually increases toward the main chip area CA in the lateral direction. In an example for implementing a structure in which the upper guard ring 236 has the variable density toward the main chip area CA, the pitch 236X of the upper guard ring 236 in the first lateral direction (X direction) and the pitch 236Y of the upper guard ring 236 in the second lateral direction (Y direction) may be configured to be constant depending on a position of the upper guard ring 236, and the second thickness 236T of the upper guard ring 236 may be configured to gradually increase toward the main chip area CA in the lateral direction. In another example for implementing the structure in which the upper guard ring 236 has the variable density toward the main chip area CA, the pitch 236X of the upper guard ring 236 may be configured to be gradually reduced toward the main chip area CA in the lateral direction, and the second thickness 236T of the upper guard ring 236 may be configured to be constant depending on a position of the upper guard ring 236.

Constituent materials of the lower guard ring 228 and the upper guard ring 236, which are shown in FIGS. 7A to 7D, may respectively and substantially be the same as those of the lower guard ring 128 and the upper guard ring 136A, which have been described with reference to FIGS. 2 to 5B. FIGS. 7A to 7D illustrate an example in which a major-axis direction of each of the plurality of first polygonal vertical holes 228H and the plurality of second polygonal vertical holes 236H is the first lateral direction (X direction), and a minor-axis direction of each of the plurality of first polygonal vertical holes 228H and the plurality of second polygonal vertical holes 236H is the second lateral direction (Y direction), but inventive concepts are not limited to the example shown in FIGS. 7A to 7D. For example, the major-axis direction of each of the plurality of first polygonal vertical holes 228H and the plurality of second polygonal vertical holes 236H may be the second lateral direction (Y direction), and the minor-axis direction of each of the plurality of first polygonal vertical holes 228H and the plurality of second polygonal vertical holes 236H may be the first lateral direction (X direction). Alternatively, each of the major-axis direction and the minor-axis direction of each of the plurality of first polygonal vertical holes 228H and the plurality of second polygonal vertical holes 236H may be an oblique direction between the first lateral direction (X direction) and the second lateral direction (Y direction).

The IC device 100 described with reference to FIGS. 7A to 7D may include the guard ring GR and the chipping dam CPD, which are located on the edge area EA surrounding the main chip area CA of a substrate 102. The guard ring GR and the chipping dam CPD may sequentially surround the main chip area CA. Each of the guard ring GR and the chipping dam CPD may include the lower guard ring 228 and the upper guard ring 236, which overlap each other in a vertical direction (Z direction) and be connected to each other. Each of the lower guard ring 228 and the upper guard ring 236 may have a network structure in which a plurality of unit structures each having a re-entrant honeycomb shape or a bow-tie shape are integrally connected to each other. When stress is applied to each of the lower guard ring 228 and the upper guard ring 236 in the first lateral direction (X direction), the stress may be transmitted in each of the first lateral direction (X direction) and the second lateral direction (Y direction). Also, each of the lower guard ring 228 and the upper guard ring 236 may have relatively high shear modulus and bulk modulus and have relatively excellent energy absorption capability. Accordingly, during the process of manufacturing the IC device 200, when a physical cutting process (e.g., a sawing process) for individualizing the IC device 200 is performed, physical damage (e.g., cracks, chipping, and breakage) may occur from a cut surface. In this case, even when the physical damage propagates to the lower guard ring 228 and the upper guard ring 236 that constitute the chipping dam (refer to CPD in FIG. 2) and/or the guard ring (refer to GR in FIG. 2), energy causing the physical damage may be easily dissipated due to the lower guard ring 228 and the upper guard ring 236, each of which has the network structure in which the plurality of unit structures each having the re-entrant honeycomb shape or the bow-tie shape are integrally connected to each other. Therefore, in the IC device 200, the dissipation ability of energy causing the physical damage transmitted from the outside may be strengthened by the lower guard ring 228 and the upper guard ring 238, which constitute each of the guard ring GR and the chipping dam CPD. As a result, the propagation of cracks, chipping, and breakage that may occur in a physical cutting process for individualizing the IC device 200 may be prevented, thereby providing the IC device 200 with improved reliability and productivity.

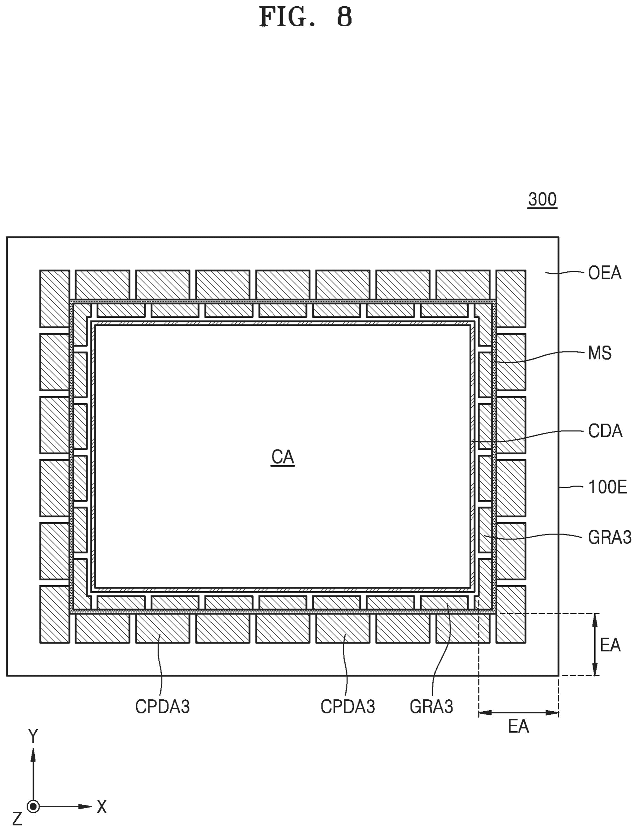

FIG. 8 is a plan view of an IC device 300 according to still other embodiments.

Referring to FIG. 8, the IC device 300 may substantially have the same configuration as the IC device 100 described with reference to FIGS. 1 to 6. However, the IC device 300 may include a guard ring area GRA3 and a chipping dam area CPDA3, which are located in an edge area EA. The guard ring area GRA3 and the chipping dam area CPDA3 may respectively and substantially have the same configurations as the guard ring area GRA and the chipping dam area CPDA, which have been described with reference to FIGS. 1 and 2. However, in a top view, each of the guard ring area GRA3 and the chipping dam area CPDA3 may have a ring shape intermittently surrounding the main chip area CA. A guard ring GR having the configuration described with reference to FIG. 2 may be located in the guard ring area GRA3, and a chipping dam CPD having the configuration described with reference to FIG. 2 may be located in the chipping dam area CPDA3. A moat structure MS may be located between the guard ring area GRA3 and the chipping dam area CPDA3. A detailed configuration of the moat structure MS may be the same as that described with reference to FIGS. 1 to 5B.

In embodiments, each of the guard ring GR located in the guard ring area GRA3 and the chipping dam CPD located in the chipping dam area CPDA3 may include a lower guard ring 128 and an upper guard ring structure UGS including a plurality of upper guard rings (e.g., 136A, 136B, 136C, and 136D) and a plurality of guard via contacts 137. The lower guard ring 128 and the upper guard ring structure UGS may have the configurations described with reference to FIGS. 2 to 5B. In other embodiments, each of the guard ring GR located in the guard ring area GRA3 and the chipping dam CPD located in the chipping dam area CPDA3 may include the lower guard ring 228 and the upper guard ring 236, which are shown in FIGS. 7A to 7D.

FIG. 8 illustrates a configuration in which each of the guard ring area GRA3 and the chipping dam area CPDA3 has a ring shape intermittently surrounding the main chip area CA in a top view, but inventive concepts are not limited thereto. For instance, only a selected one of the guard ring area GRA3 and the chipping dam area CPDA3 may have a ring shape intermittently surrounding the main chip area CA, while the other one thereof may have a ring shape continuously surrounding the main chip area CA without being cut off as shown in FIG. 1.

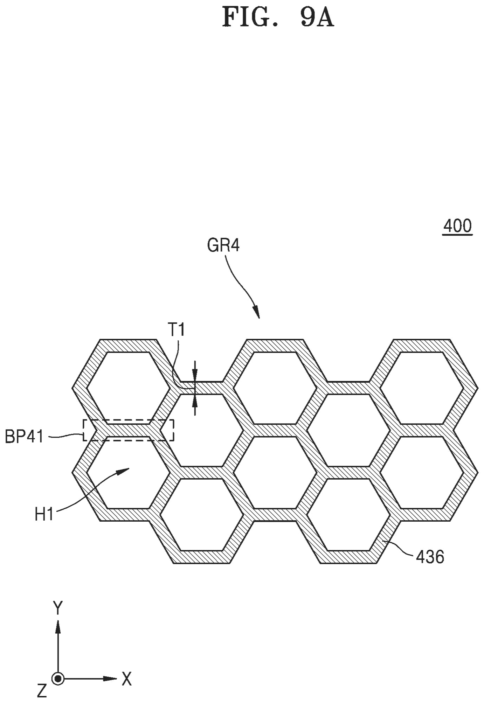

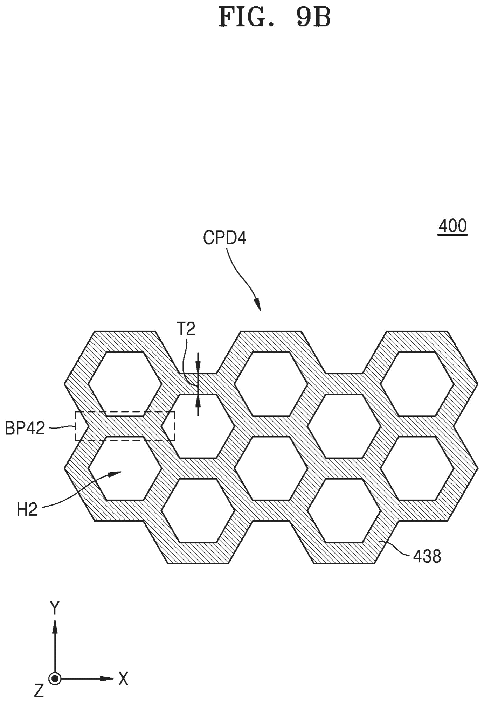

FIGS. 9A and 9B are plan views of a guard ring GR4 and a chipping dam CPD4 of an IC device 400 according to embodiments.

Referring to FIGS. 9A and 9B, the IC device 400 may substantially have the same configuration as the IC device 100 described with reference to FIGS. 1 to 6. However, the guard ring GR4 and the chipping dam CPD4 of the IC device 400 may include network structures having different shapes. More specifically, in the IC device 400, the guard ring GR4 may include a first network structure 436 in which a plurality of unit structures each having a honeycomb shape are integrally connected to each other as shown in FIG. 9A. As shown in FIG. 9B, the chipping dam CPD4 may include a second network structure 438 in which a plurality of unit structures each having a honeycomb shape are integrally connected to each other.

The first network structure 436 included in the guard ring GR4 may include a plurality of first bar components BP41 defining a plurality of first vertical holes H1 each having a hexagonal planar shape, and each of the plurality of first bar components BP41 may have a first thickness T1 in a lateral direction. The second network structure 438 included in the chipping dam CPD4 may include a plurality of second bar components BP42 defining a plurality of second vertical holes H2 each having a hexagonal planar shape, and each of the plurality of second bar components BP42 may have a second thickness T2 in the lateral direction. The second thickness T2 may be greater than the first thickness T1. In a first lateral direction (X direction) and a second lateral direction (Y direction), a pitch of the plurality of first vertical holes H1 included in the guard ring GR4 may be substantially equal to a pitch of the plurality of second vertical holes H2 included in the chipping dam CPD4.

In embodiments, a length of each of the plurality of first bar components BP41 of the guard ring GR4 and the plurality of second bar components BP42 of the chipping dam CPD4 may be selected in a range of about 0.3 µm to about 2.0 µm, without being limited thereto. In embodiments, the first thickness T1 of each of the plurality of first bar components BP41 of the guard ring GR4 may be selected in a range of about 0.10 µm to about 0.15 µm, and the second thickness T2 of each of the plurality of second bar components BP42 of the chipping dam CPD4 may be selected in a range of about 0.20 µm to about 0.30 µm, without being limited thereto.

According to the IC devices 300 and 400 described with reference to FIGS. 8, 9A, and 9B, similarly to the IC devices 100 and 200 described with reference to FIGS. 1 to 7D, the propagation of cracks, chipping, and breakage that may occur in a physical cutting process for individualizing the IC devices 300 and 400 may be blocked, thereby providing the IC devices 300 and 400 with improved reliability and productivity.

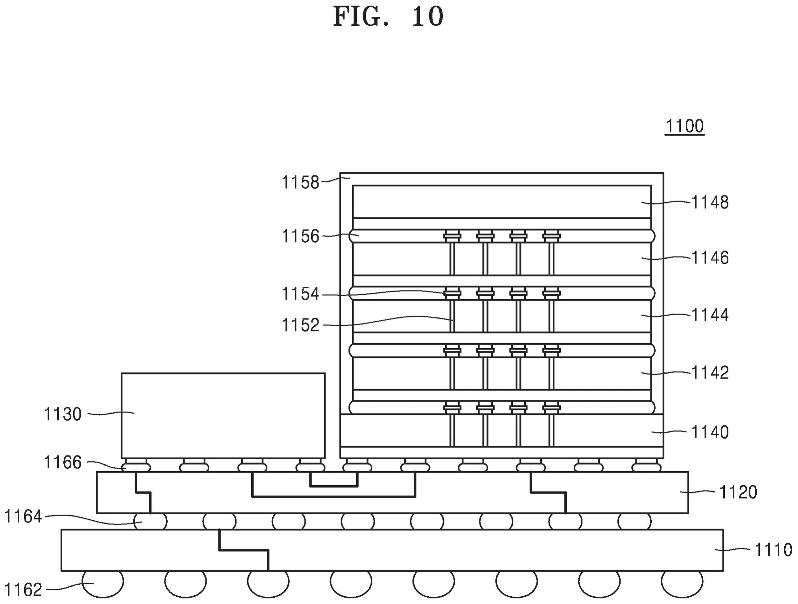

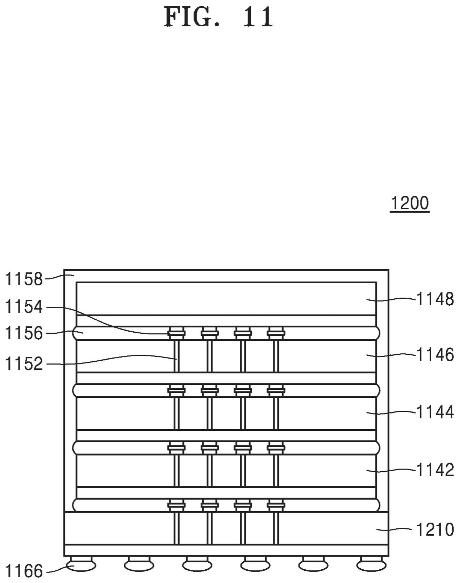

FIGS. 10 and 11 are respectively cross-sectional views of semiconductor packages 1100 and 1200 according to embodiments. Each of the semiconductor packages 1100 and 1200 may include hybrid memory cube (HMC), HBM, fifth-generation double-data-rate (DDR5) DRAM, or a combination thereof. In FIGS. 10 and 11, the same reference numerals are used to denote the same elements, and repeated descriptions thereof are omitted.

Referring to FIG. 10, the semiconductor package 1100 may include a printed circuit board (PCB) 1110, a relay board 1120, a microprocessor (MP) 1130, a base chip 1140, a plurality of memory chips (e.g., 1142, 1144, 1146, and 1148, a plurality of bumps (e.g., 1154, 1162 1164, 1166), an adhesive layer 1156, and an encapsulant 1158.

The plurality of memory chips (e.g., 1142, 1144, 1146, and 1148) may be sequentially stacked on the base chip 1140. The plurality of memory chips (e.g., 1142, 1144, 1146, and 1148) may include a plurality of through electrodes 1152. The PCB 1110 may include a rigid PCB, a flexible PCB, or a rigidflexible PCB. The PCB 1110 may include a multilayered circuit board. The PCB 1110 may include a package substrate or a main board. A plurality of bumps 1162 may be located on a bottom surface of the PCB 1110. The relay board 1120 may be located on the PCB 1110. A plurality of bumps 1164 may be located between the PCB 1110 and the relay board 1120.

The MP 1130, the base chip 1140, and the plurality of memory chips (e.g., 1142, 1144, 1146, and 1148) may be located on the relay board 1120. The relay board 1120 may include a semiconductor substrate, such as a silicon interposer. A plurality of bumps 1166 may be located between the relay board 1120 and the MP 1130 and between the relay board 1120 and the base chip 1140. The MP 1130 may include various kinds of processors, such as a graphics processing unit (GPU) or an application processor (AP). The base chip 1140 may include various elements, such as a memory controller. The base chip 1140 may be connected to the MP 1130 via the relay board 1120 and the plurality of bumps 1166. Each of the plurality of memory chips (e.g., 1142, 1144, 1146, and 1148) may include the IC devices 100, 200, 300, and 400 described with reference to FIGS. 1 to 9B or an IC device having variously changed structures within the scope of inventive concepts. The plurality of through electrodes 1152 may pass through a substrate (refer to 102 in FIG. 2). The adhesive layer 1156 may be located between two adjacent ones of the plurality of memory chips (e.g., 1142, 1144, 1146, and 1148). The adhesive layer 1156 may include a nonconductive film (NCF). A plurality of bumps 1154 may be respectively located between the plurality of memory chips (e.g., 1142, 1144, 1146, and 1148), and a plurality of bumps 1154 may be located between the memory chip 1142 and the base chip 1140. The plurality of bumps 1154 may be surrounded by the adhesive layer 1156 and pass through the adhesive layer 1156. The plurality of memory chips (e.g., 1142, 1144, 1146, and 1148) may be connected to the base chip 1140 via the plurality of bumps 1154 and the plurality of through electrodes 1152.

The encapsulant 1158 may cover the plurality of memory chips (e.g., 1142, 1144, 1146, and 1148) on the base chip 1140. The encapsulant 1158 may include an epoxy mold compound (EMC). The base chip 1140 may include a buffer chip, a logic chip, or a combination thereof. Each of the plurality of memory chips (e.g., 1142, 1144, 1146, and 1148) may include a DRAM core chip. The memory chip 1142 may include a master chip. Each of the memory chips 1144, 1146, and 1148 may include a slave chip.

Referring to FIG. 11, the semiconductor package 1200 may include the plurality of memory chips (e.g., 1142, 1144, 1146, and 1148), which are sequentially stacked on a package substrate 1210. The package substrate 1210 may include a PCB, such as a rigid PCB, a flexible PCB, or a rigid- flexible PCB. The adhesive layer 1156 may be located between two adjacent ones of the plurality of memory chips (e.g., 1142, 1144, 1146, and 1148) and between the memory chip 1142 and the package substrate 1210. The adhesive layer 1156 may include an NCF. The plurality of memory chips (e.g., 1142, 1144, 1146, and 1148) may be connected to the package substrate 1210 via the plurality of bumps 1154 and the plurality of through electrodes 1152. The encapsulant 1158 may be located on the package substrate 1210 to cover the plurality of memory chips (e.g., 1142, 1144, 1146, and 1148). A plurality of bumps 1166 may be located on a bottom surface of the package substrate 1210.

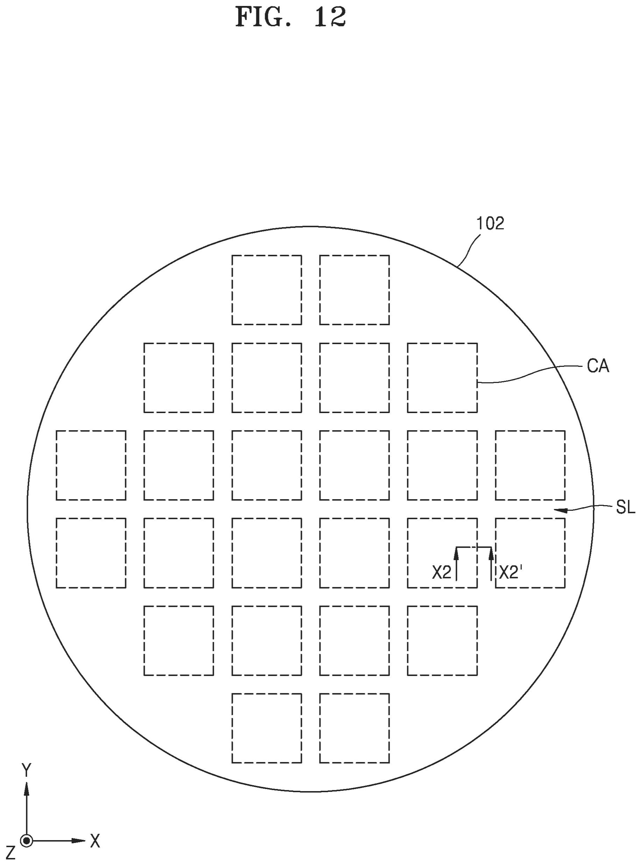

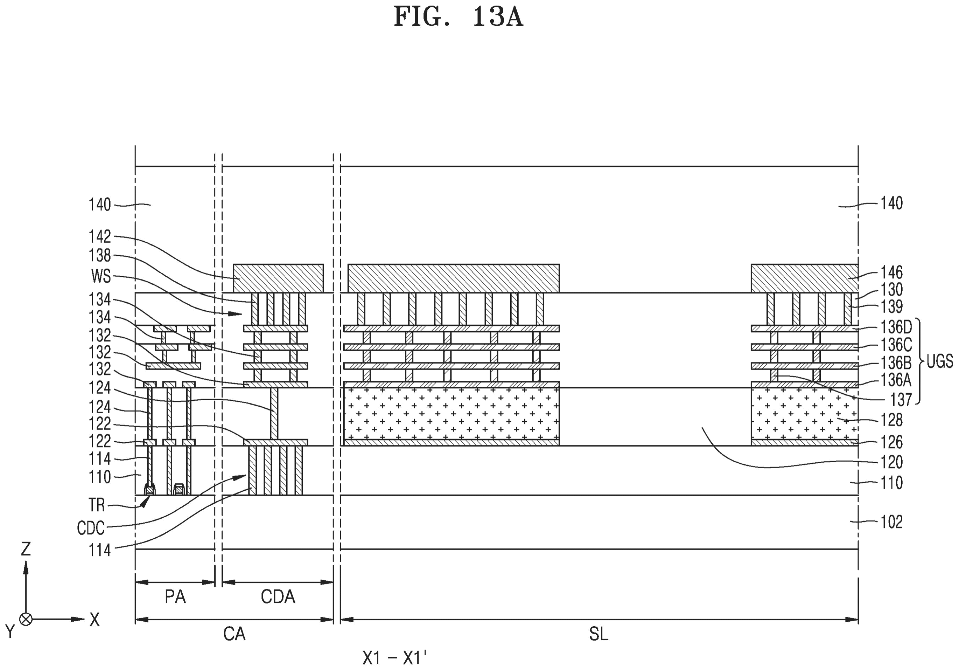

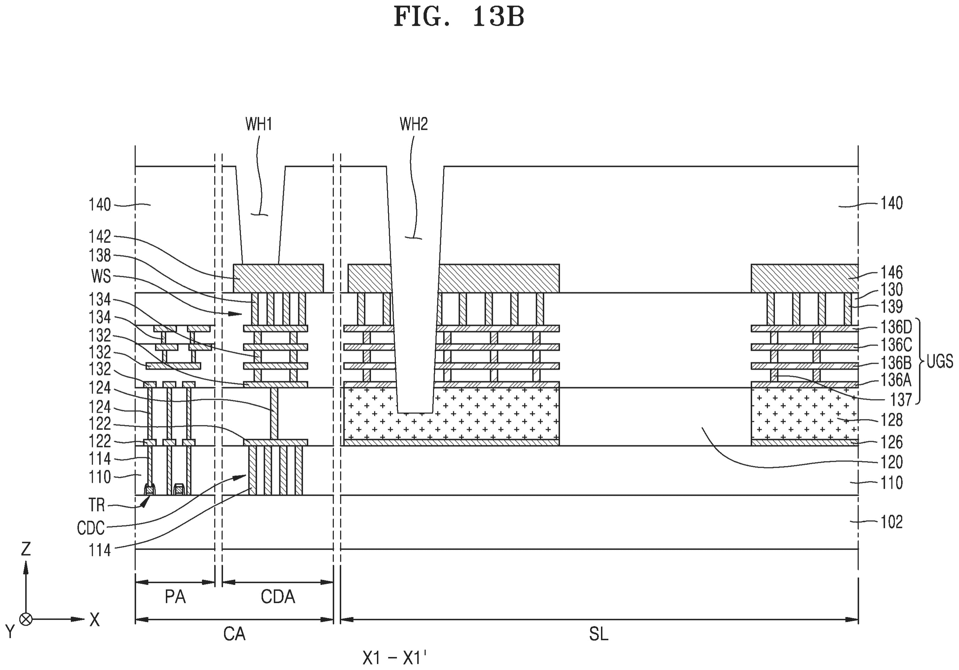

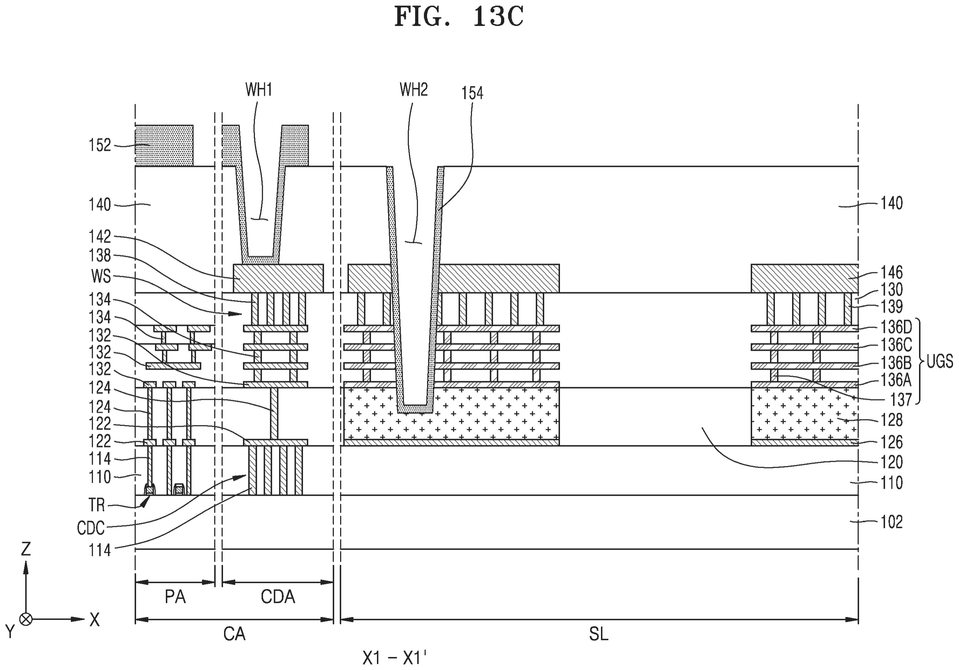

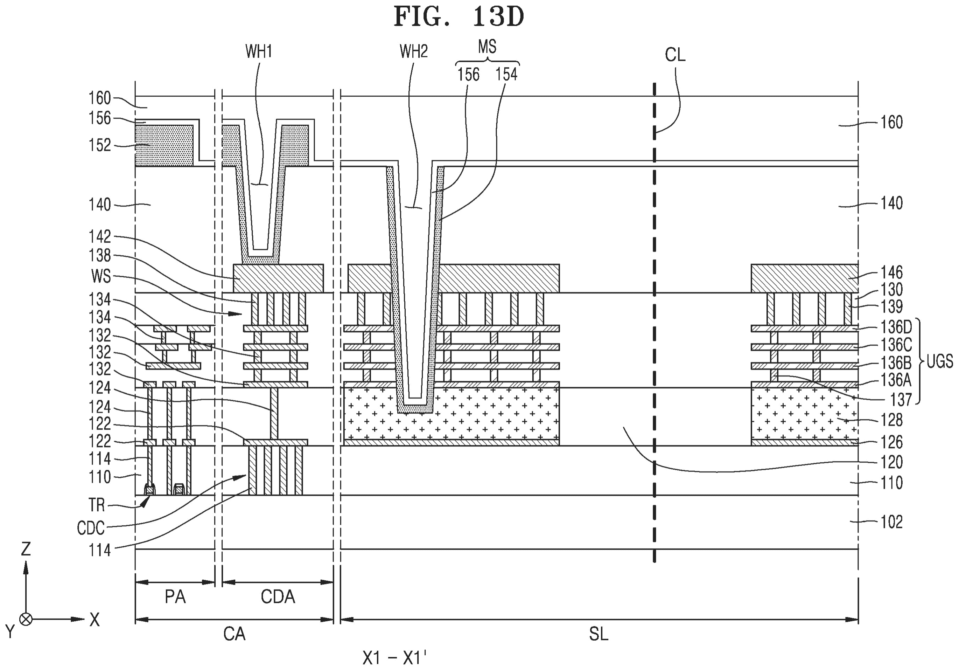

FIG. 12 is a plan view of a wafer that may be used in a method of manufacturing an IC device, according to embodiments. FIGS. 13A to 13D are cross-sectional views of a process sequence of a method of manufacturing an IC device, according to embodiments. FIGS. 13A, 13B, 13C, and 13D each illustrate some components of a portion corresponding to a cross-section taken along line X2-X2' of FIG. 12, according to a process sequence. An example of a method of manufacturing the IC device 100 described with reference to FIGS. 1 to 6 is described with reference to FIGS. 12 and 13A to 13D. In FIGS. 12 and 13A to 13D, the same reference numerals are used to denote the same elements as in FIGS. 1 to 6, and repeated descriptions thereof are omitted.

Referring to FIGS. 12 and 13A, a substrate 102 may be provided. The substrate 102 may include a plurality of main chip areas CA and a scribe lane area SL located between two adjacent ones of the plurality of main chip areas CA.

A main chip structure may be formed in each of the plurality of main chip areas CA, and a scribe lane structure may be formed in the scribe lane area SL. The main chip structure may include a plurality of devices (e.g., memory devices or logic devices), a plurality of transistors TR, a plurality of wiring structures WS, a chipping detect circuit CDC, and a plurality of interlayer insulating films (e.g., 110, 120, 130, and 140). The plurality of wiring structures WS and the chipping detect circuit CDC may respectively include a plurality of wiring patterns (e.g., 122, 132, and 142) and a plurality of conductive contacts (e.g., 114, 124, 134, and 138). Also, the scribed lane structure may include a plurality of planar conductive layers 126, a plurality of lower guard rings 128, a plurality of upper guard ring structures UGS, a plurality of upper guard via contacts 139, an upper guard wiring layer 146, and a plurality of interlayer insulating films (e.g., 110, 120, 130, and 140). The plurality of interlayer insulating films (e.g., 110, 120, 130, and 140) may cover respective portions of the plurality of planar conductive layers 126, the plurality of lower guard rings 128, the plurality of upper guard ring structures UGS, the plurality of upper guard via contacts 139, and the upper guard wiring layer 146.

More specifically, the plurality of transistors TR may be formed in the peripheral circuit area PA of each of the plurality of main chip areas CA, and the interlayer insulating film 110 may be formed to cover the plurality of transistors TR in the plurality of main chip areas CA and extend to the scribe lane area SL. Then, the plurality of conductive contacts 114 passing through the interlayer insulating film 110 in a vertical direction (Z direction) may be formed in the peripheral circuit area PA and the chipping detection area CDA of the plurality of main chip areas CA.

Next, the plurality of wiring patterns 122 and the plurality of planar conductive layers 126 may be formed simultaneously. The plurality of wiring patterns 122 may be located on the interlayer insulating film 110 in the peripheral circuit area PA and the chipping detection area CDA of the plurality of main chip areas CA. The plurality of planar conductive layers 126 may be located on the interlayer insulating film 110 in the scribe lane area SL. Thereafter, the plurality of conductive contacts 124, the plurality of lower guard rings 128, and the interlayer insulating film 120 may be formed. The plurality of conductive contacts 124 may be connected to the plurality of wiring patterns 122 in the plurality of main chip areas CA, and the plurality of lower guard rings 128 may be connected to the plurality of planar conductive layers 126 in the scribe lane area SL. The interlayer insulating film 120 may fill respective spaces between the plurality of conductive contacts 124 and the plurality of lower guard rings 128. The plurality of conductive contacts 124 may be formed simultaneously with the plurality of lower guard rings 128.

Afterwards, the plurality of wiring patterns 132 and the plurality of conductive contacts 134 and 138 may be formed on the interlayer insulating film 120 in the peripheral circuit area PA and the chipping detection area CDA of the plurality of main chip areas CA, and the plurality of upper guard ring structures UGS may be formed on the plurality of lower guard rings 128 in the scribe lane area SL. The plurality of upper guard via contacts 139 may be formed on the plurality of upper guard ring structures UGS, and the interlayer insulating film 130 may be formed on the interlayer insulating film 120 to cover at least a portion of each of conductive elements. Each of a plurality of upper guard rings (e.g., 136A, 136B, 136C, and 136D) included in the plurality of upper guard ring structures UGS may be formed simultaneously with some of the plurality of wiring patterns 132 located in the peripheral circuit area PA and the chipping detection area CDA of the main chip area CA. A plurality of guard via contacts 137 included in the plurality of upper guard ring structures UGS may be each formed simultaneously with some of the plurality of conductive contacts 134. The plurality of upper guard via contacts 139 located on the plurality of upper guard ring structures UGS may be formed simultaneously with the plurality of conductive contacts 138.

Afterwards, a plurality of wiring patterns 142 may be formed on the plurality of conductive contacts 138 and the interlayer insulating film 130 in the plurality of main chip areas CA. A plurality of upper guard wiring layers 146 may be simultaneously formed on the plurality of upper guard via contacts 139 and the interlayer insulating film 130 in the scribe lane area SL. An interlayer insulating film 140 may be formed to cover the plurality of wiring patterns 142 and the plurality of upper guard wiring layers 146 on the plurality of main chip areas CA and the scribe lane area SL.

Referring to FIG. 13B, in the resultant structure of FIG. 13A, a plurality of first holes WH1 and a plurality of second holes WH2 may be formed. The plurality of first holes WH1 may pass through the interlayer insulating film 140 in the vertical direction (Z direction) in the plurality of main chip areas CA and each expose the wiring pattern 142 at the bottom. The plurality of second holes WH2 may pass through the interlayer insulating film 140, the upper guard wiring layer 146, the upper guard ring structure UGS, and the interlayer insulating films 130 in the vertical direction (Z direction) in the scribe lane area SL and each expose the lower guard ring 128 at the bottom. The plurality of second holes WH2 may pass through a portion of the lower guard ring 128 in the vertical direction (Z direction).

Referring to FIG. 13C, in the resultant structure of FIG. 13B, a plurality of redistribution layers 152 and a plurality of metal moat patterns 154 may be formed. The plurality of redistribution layers 152 may cover the interlayer insulating film 140 on the plurality of main chip areas CA and be connected to the wiring pattern 142. The plurality of metal moat patterns 154 may conformally cover inner surfaces of the plurality of second holes WH2 on the scribe lane area SL. The plurality of redistribution layers 152 may be formed simultaneously with the plurality of metal moat patterns 154. During the formation of the plurality of redistribution layers 152 and the plurality of metal moat patterns 154, a plurality of TEGs (refer to 180 in FIG. 6) may be formed in the scribe lane area SL between a pair of upper guard ring structures UGS, which are adjacent to each other in a lateral direction (e.g., X direction or Y direction). The plurality of TEGs 180 may pass through the interlayer insulating film 140 and be connected to one of the plurality of wiring patterns 142.

Referring to FIG. 13D, in the resultant structure of FIG. 13C, an insulating liner 156 may be formed to conformally cover the plurality of redistribution layers 152 located in the plurality of main chip areas CA, the plurality of metal moat patterns 154 located in the scribe lane area SL, and the top surface of the interlayer insulating film 140, and an outermost insulating film 160 having a planarized top surface may be formed on the insulating liner 156. The outermost insulating film 160 may be formed to fill the remaining space of each of the first hole WH1 and the second hole WH2 on the insulating liner 156.

During the formation of the resultant structure of FIG. 13D, a plurality of measurement marks (refer to MK in FIG. 6) may be formed on the scribe lane area SL between a pair of lower guard rings 128 and/or between the pair of upper guard ring structures UGS, which are adjacent to each other in the lateral direction (e.g., X direction or Y direction).

Thereafter, a cutting process for individualizing the IC device 100 may be performed along a path indicated by a cut line CL in the scribe lane area SL of FIG. 13D. The cutting process may be performed by using a sawing blade or a laser. During the cutting process, physical damage (e.g., cracks, chipping, and breakage) may occur from a cut surface obtained from the resultant structure of FIG. 13D and propagate toward the plurality of main chip areas CA. In the manufacturing method according to inventive concepts, even when the physical damage propagates toward the plurality of main chip areas CA during the cutting process, because a chipping dam CPD and a guard ring GR are located around each of the plurality of main chip areas CA, energy causing the physical damage may be easily dissipated due to the lower guard ring 128 and the plurality of upper guard rings (e.g., 136A, 136B, 136C, and 136D), which constitute the chipping dam CPD and/or the guard ring GR and each have a honeycomb-shaped mesh structure, when the physical damage propagates to the chipping dam CPD and/or the guard ring GR. As a result, the propagation of cracks, chipping, and breakage that may occur from a physical cutting process for individualizing the IC device 100 may be prevented, and thus, the IC device 100 with improved reliability and productivity may be provided.

Although the method of manufacturing the IC device 100 shown in FIGS. 1 to 6 has been described with reference to FIGS. 12 and 13A to 13D, it will be understood that the IC devices 200, 300, and 400 shown in FIGS. 7A to 9B and IC devices having variously changed structures may be manufactured by applying various modifications and changes to the processes described with reference to FIGS. 12 and 13A to 13D within the scope of inventive concepts.

According to an example embodiment, a method of manufacturing an integrated circuit device may include: providing a substrate; forming a guard ring at a first vertical level on the substrate, wherein the first vertical level may be spaced apart from a main surface of the substrate in a vertical direction and the vertical direction may be orthogonal to the main surface; and forming a chipping dam at the first vertical level on the substrate, the chipping dam surrounding the guard ring. The guard ring and the chipping dam each may include a lower guard ring and an upper guard ring structure spaced apart in the vertical direction from the substrate with the lower guard ring therebetween. The lower guard ring may include a first mesh structure defining a plurality of first polygonal vertical holes in a top view. The upper guard ring structure may include at least one upper guard ring. The at least one upper guard ring may include a second mesh structure defining a plurality of second polygonal vertical holes in the top view.

In embodiments, the upper guard ring structure may include a plurality of upper guard rings overlapping each other in the vertical direction and spaced apart from each other in the vertical direction, and a plurality of guard via contacts between a pair of upper guard rings among the plurality of upper guard rings. The plurality of guard via contacts may be connected to each upper guard ring of the pair of upper guard rings, and the pair of upper guard rings may correspond to two of the plurality of upper guard rings that are adjacent to each other in the vertical direction.

In some embodiments, the plurality of first polygonal vertical holes in the lower guard ring may be hexagonal, the plurality of second polygonal vertical holes in the at least one upper guard ring may be hexagonal, and each of the lower guard ring and the at least one upper guard ring may have a network structure in which a plurality of unit structures having a honeycomb shape may be integrally connected to each other.

In some embodiments, each of the plurality of first polygonal vertical holes in the lower guard ring and the plurality of second polygonal vertical holes in the at least one upper guard ring may include a hole having a re-entrant honeycomb shape, and each of the lower guard ring and the at least one upper guard ring may have a network structure in which a plurality of unit structures having a re-entrant honeycomb shape may be integrally connected to each other.

In some embodiments, a length of the lower guard ring in the vertical direction may be greater than a length of the at least one upper guard ring in the vertical direction.

## Claims

1. An integrated circuit device (100) comprising:
a substrate (102);
a guard ring (GR) at a first vertical level on the substrate (102), wherein the first vertical level is spaced apart from a main surface (102M) of the substrate (102) in a vertical direction (Z) and the vertical direction (Z) is orthogonal to the main surface (102M); and
a chipping dam (CPD) at the first vertical level on the substrate (102), the chipping dam (CPD) surrounding the guard ring (GR), wherein
the guard ring (GR) and the chipping dam (CPD) each comprise a lower guard ring (128) and an upper guard ring structure (UGS) spaced apart in the vertical direction (Z) from the substrate (102) with the lower guard ring (128) therebetween,
the lower guard ring (128) comprises a first mesh structure defining a plurality of first polygonal vertical holes (128H) in a top view,
the upper guard ring structure (UGS) comprises at least one upper guard ring (136), and
the at least one upper guard ring (136) comprises a second mesh structure defining a plurality of second polygonal vertical holes (136H) in the top view.

2. The integrated circuit device (100) of claim 1, wherein:
the upper guard ring structure (UGS) comprises:
a plurality of upper guard rings (136) overlapping each other in the vertical direction (Z) and spaced apart from each other in the vertical direction (Z), and
a plurality of guard via contacts (137) between a pair of upper guard rings (136) among the plurality of upper guard rings (136), and
wherein:
the plurality of guard via contacts (137) are connected to each upper guard ring (136) of the pair of upper guard rings (136), and
the pair of upper guard rings (136) correspond to two of the plurality of upper guard rings (136) that are adjacent to each other in the vertical direction (Z).

3. The integrated circuit device (100) of claim 1 or 2, wherein:
the plurality of first polygonal vertical holes (128H) in the lower guard ring (128) are hexagonal,
the plurality of second polygonal vertical holes (136H) in the at least one upper guard ring (136) are hexagonal, and
each of the lower guard ring (128) and the at least one upper guard ring (136) has a network structure (436, 438) in which a plurality of unit structures having a honeycomb shape are integrally connected to each other.

4. The integrated circuit device (100) of any one of claims 1 to 3, wherein:
each of the plurality of first polygonal vertical holes (128H) in the lower guard ring (128) and the plurality of second polygonal vertical holes (136H) in the at least one upper guard ring (136) comprises a hole having a re-entrant honeycomb shape, and
each of the lower guard ring (128) and the at least one upper guard ring (136) has a network structure (436, 438) in which a plurality of unit structures having a re-entrant honeycomb shape are integrally connected to each other.

5. The integrated circuit device (100) of any one of claims 1 to 4, wherein a length of the lower guard ring (128) in the vertical direction (Z) is greater than a length of the at least one upper guard ring (136) in the vertical direction (Z).

6. The integrated circuit device (100) of any one of claims 1 to 5, wherein:
in the lower guard ring (128), a plurality of first bar components (BP11) define the plurality of first polygonal vertical holes (128H) of the first mesh structure, and the plurality of first bar components (BP11) have a first thickness (128T) in a lateral direction (X, Y),
in the at least one upper guard ring (136), a plurality of second bar components (BP12) define the plurality of second polygonal vertical holes (136H) of the second mesh structure, and the plurality of second bar components (BP12) have a second thickness (136T) in the lateral direction (X, Y), and
the first thickness (128T) is equal to the second thickness (136T).

7. The integrated circuit device (100) of any one of claims 1 to 6, wherein:
in the lower guard ring (128), each a plurality of first bar components (BP11) define the plurality of first polygonal vertical holes (128H) of the first mesh structure, and the plurality of first bar components (BP11) have a first thickness (128T) in a lateral direction (X, Y),
in the at least one upper guard ring (136), a plurality of second bar components (BP12) define the plurality of second polygonal vertical holes (136H) of the second mesh structure, and the plurality of second bar components (BP12) have a second thickness (136T) in the lateral direction (X, Y), and
the first thickness (128T) is different from the second thickness (136T).

8. An integrated circuit device (100) comprising:
a substrate (102) having a main chip area (CA) and an edge area (EA) surrounding the main chip area (CA) in a top view;
a guard ring (GR) on the edge area (EA) of the substrate (102), the guard ring (GR) surrounding the main chip area (CA) in the top view; and
a chipping dam (CPD) on the edge area (EA) of the substrate (102) and spaced apart in a lateral direction (X, Y) from the main chip area (CA) with the guard ring therebetween, the chipping dam (CPD) surrounding the main chip area (CA) and the guard ring (GR) in the top view, wherein the lateral direction (X, Y) is parallel to a main surface (102M) of the substrate (102), wherein
the guard ring (GR) and the chipping dam (CPD) each comprise a lower guard ring (128) and an upper guard ring structure (UGS) spaced apart in a vertical direction (Z) from the substrate (102) with the lower guard ring (128) therebetween,
the lower guard ring (128) comprising a first mesh structure defining a plurality of first polygonal vertical holes (128H) in the top view,
the upper guard ring structure (UGS) comprises at least one upper guard ring (136), and the at least one upper guard ring (136) comprises a second mesh structure defining a plurality of second polygonal vertical holes (136H) in the top view.

9. The integrated circuit device (100) of claim 8, wherein the upper guard ring structure (UGS) comprises:
a plurality of upper guard rings (136) overlapping each other in the vertical direction (Z) and spaced apart from each other in the vertical direction (Z); and
a plurality of guard via contacts (137) between a pair of upper guard rings (136) among the plurality of upper guard rings (136), wherein
the plurality of guard via contacts (137) are connected to each upper guard ring (136) of the pair of upper guard rings (136), and the pair of upper guard rings (136) correspond to two of the plurality of upper guard rings (136) that are adjacent to each other in the vertical direction (Z).

10. The integrated circuit device (100) of claim 8 or 9, wherein:
the plurality of first polygonal vertical holes (128H) in the lower guard ring (128) and the plurality of second polygonal vertical holes (136H) in the at least one upper guard ring (136) are hexagonal, and
each of the lower guard ring (128) and the at least one upper guard ring (136) has a network structure (436, 438) in which a plurality of unit structures having a honeycomb shape are integrally connected to each other.

11. The integrated circuit device (100) of any one of claims 8 to 10, wherein:
each of the plurality of first polygonal vertical holes (128H) included in the lower guard ring (128) and the plurality of second polygonal vertical holes (136H) included in the at least one upper guard ring (136) comprises a hole having a re-entrant honeycomb shape, and
each of the lower guard ring (128) and the at least one upper guard ring (136) has a network structure (436, 438) in which a plurality of unit structures each having a re-entrant honeycomb shape are integrally connected to each other.

12. The integrated circuit device (100) of any one of claims 8 to 11, further comprising:
a moat structure (MS) between the guard ring (GR) and the chipping dam (CPD) on the edge area (EA) of the substrate (102), the moat structure (MS) surrounding the main chip area (CA) and the guard ring (GR) in the top view, wherein
the at least one upper guard ring (136) of each of the guard ring (GR) and the chipping dam (CPD) are in contact with an outer sidewall of the moat structure (MS), and
the lower guard ring (128) of each of the guard ring (GR) and the chipping dam (CPD) is in contact with a bottom surface of the moat structure (MS) between the substrate (102) and the moat structure (MS).

13. The integrated circuit device (100) of any one of claims 8 to 12, wherein the moat structure (MS) comprises:
a metal moat pattern (154) in contact with the at least one upper guard ring (136) of each of the guard ring (GR) and the chipping dam (CPD), the metal moat pattern (154) having a U cross-sectional shape defining an inner space; and
an insulating liner (156) in contact with an inner surface of the metal moat pattern (154) in the inner space defined by the metal moat pattern (154), wherein
a vertical level of an uppermost top surface of the metal moat pattern (154) is farther from the substrate (102) than a vertical level of an uppermost top surface of the guard ring (GR) and a vertical level of an uppermost top surface of the chipping dam (CPD).

14. The integrated circuit device (100) of claim 8, further comprising:
a moat structure (MS) between the guard ring (GR) and the chipping dam (CPD) on the edge area (EA) of the substrate (102), the moat structure (MS) comprising a metal moat pattern (154) surrounding the main chip area (CA) and the guard ring (GR);
a wiring structure (WS) on the main chip area (CA) of the substrate (102), the wiring structure (WS) comprising a plurality of wiring patterns (122, 132, 142) at a same vertical level as a vertical level of the guard ring (GR) and a vertical level of the chipping dam (CPD) on the substrate (102); and
a redistribution structure (RDS) on the wiring structure (WS) on the main chip area (CA) of the substrate (102), the redistribution structure (RDS) comprising a plurality of redistribution layers (152) that are connected to the wiring structure (WS), wherein
a metal in the metal moat pattern (154) of the moat structure (MS) is same as a metal in the plurality of redistribution layers (152) of the redistribution structure (RDS), and
a vertical level of the metal moat pattern (154) of the moat structure (MS) is same as a vertical level as at least some of the plurality of redistribution layers (152) in the redistribution structure (RDS) on the substrate (102).

15. The integrated circuit device (100) of claim 8, further comprising:
a chipping detect circuit (CDC) on an outermost portion of the main chip area (CA) of the substrate (102), wherein the chipping detect circuit (CDC) is adjacent to the guard ring (GR) in the lateral direction (X, Y), and in the top view, the chipping detect circuit (CDC) is surrounded by the guard ring (GR).
